# FASCICULE DE BREVET EUROPEEN

(11) **EP 1 161 034 B1**
(45) Date de publication et mention de la délivrance du brevet: **19.08.2009**
(21) Numéro de dépôt: 01401290.0
(22) Date de dépôt: 17.05.2001
(51) Int. Cl.: H04L 12/56, G06F 7/544, G06F 7/02

(54) **Dispositif de sélection par valeur numérique d'au moins un élément parmi des éléments candidats à la sélection**
Wahlvorrichtung aufgrund numerischer Werte zur Auswahl von mindestens eines Element von Auswahl Kandidaten
Selecting apparatus based on numerical values for selecting at least one element between candidates for selection

(30) Priorité: 29.05.2000 FR 0006842
(43) Date de publication de la demande: 05.12.2001
(73) Titulaire: Alcatel Lucent, 75008 Paris (FR)
(72) Inventeur: Henrion, Michel, 1180 Bruxelles (BE)
(74) Mandataire: Sciaux, Edmond

(56) Documents cités:
- US-A- 5 245 603
- PATENT ABSTRACTS OF JAPAN vol. 007, no. 138 (P-204), 16 juin 1983 (1983-06-16) & JP 58 052745 A (NIPPON DENSHIN DENWA KOSHA), 29 mars 1983 (1983-03-29)

## Description

### 1- domaine de l'invention

### 1.1 - domaine général

Le domaine de l'invention est celui de la recherche, ou de la sélection, d'éléments par valeur numérique, parmi N valeurs numériques. Une telle sélection peut consister en la recherche du ou des éléments ayant la plus grande valeur, la plus petite valeur, ou encore une valeur donnée.

Ces valeurs numériques peuvent représenter tout type d'informations, telles que des températures, des dimensions physiques, etc... Par la suite, et sans que cela soit limitatif de la portée de la présente demande de brevet, on décrit plus particulièrement un exemple classique où les valeurs numériques représentent des niveaux de priorité.

### 1.2 - exemple de domaines d'application

L'invention trouve par exemple des applications dans le domaine des télécommunications.

La nécessité d'effectuer divers types de "sélection" ou de "tri" d'éléments de manière efficace dans les équipements de grande puissance des systèmes de communication à large bande (par exemple des systèmes de commutation asynchrone de cellules ou de paquets) où l'efficacité se mesure principalement par le compromis entre la vitesse (durée du cycle de fonctionnement) et la complexité (surface de puce nécessaire à la mise en oeuvre).

### 1.3 - définitions

Les termes "sélection" et "tri" sont utilisés par la suite avec la signification suivante :
- "Sélection" désigne de manière spécifique la sélection ordonnée d'éléments en fonction de leur rang dans un classement ordonné de ces éléments à l'aide d'une "valeur numérique" associée à chacun d'entre eux, celle-ci pouvant représenter par exemple un rang d'ordre, un niveau de priorité, ou un paramètre temporel affecté à un élément ;
- "Tri" désigne ici de manière spécifique la sélection d'éléments en fonction d'un certain identificateur de tri, appelé "clé de tri", chaque opération de tri consistant à identifier (sélectionner) tous les éléments appartenant à une classe de tri donnée, c'est-à-dire ayant une valeur numérique de clé de tri donnée.

Pour illustrer ces deux termes, on peut considérer des valeurs numériques associées à un certain nombre d'éléments afin d'effectuer une opération soit de "sélection" (par rang), soit de "tri" (par classe), la première consistant à sélectionner par exemple les éléments ayant la plus grande (ou la plus petite) valeur numérique, et la dernière consistant à identifier les éléments ayant une valeur numérique donnée.

Par la suite, on considère d'une manière générale que :
- M éléments possibles peuvent être traités par le dispositif de l'invention ;
- C éléments candidats participent vraiment à l'opération de "sélection" ou de "tri" (0 ≤ C ≤ M) ;
- Chaque élément candidat se voit associer une valeur numérique représentant soit un "paramètre de rang" pour une opération de "sélection de rang", soit un "paramètre de clé de tri" pour une opération de "tri de classe d'élément" (le même paramètre pouvant même être utilisé pour les deux types d'opérations) ;
- La valeur numérique du paramètre de "rang" ou de "clé de tri" est codée sur P bits permettant de définir N valeurs de paramètres distinctes (le type de codage fait l'objet d'une plus ample discussion).

### 2 - art antérieur

De nombreuses techniques de sélection et de tri sont bien sûr connues. On connaît en particulier un algorithme de recherche consistant à comparer les bits homologues de chaque mot binaire, successivement en partant du poids le plus fort, et en filtrant à chaque étape par bit les mots éliminés. Le chapitre 3.4 (« The word-parallel, bit-serial CAM ») du livre « Content-Addressable Memories » de T. Kohonen (University of Helsinski, Finland) (Springer-Verlag Berlin Heidelberg New-York, 1980) met en oeuvre ce principe à l'aide d'un matrice de M mots x P bits. Toutefois, cette technique décrite par étape successive présente un certain nombre d'inconvénients, en termes de vitesse de traitement et de complexité.

Par ailleurs, le document US 5.245.603 décrit une 'unité de détermination' ["Determination Unit"] comprenant une 'unité de priorité' ["Priority Unit"] suivie d'une 'unité d'arbitrage' ["Arbiter unit"]. Mis à part les notations, cette 'unité de priorité' est elle-même décrite comme un dispositif de sélection par valeur numérique de sélection d'au moins un élément parmi un sous-ensemble de C éléments candidats à la sélection, faisant partie d'un ensemble de M éléments possibles, une valeur numérique de sélection étant affectée à chacun desdits M éléments possibles, parmi N valeurs numériques de sélection possibles. Ce dispositif met en oeuvre une matrice de sélection par priorité, à deux dimensions, comprenant M x P cellules de sélection organisées en M lignes et P colonnes, P étant le nombre d'éléments binaires, ou bits, nécessaires au codage de N valeurs distinctes, la cellule (i, j) correspondant à l'intersection d'une ligne de l'élément i et d'une colonne du bit j. Chacun des M éléments possibles correspond à une desdites M lignes, à laquelle est associée la valeur numérique de sélection affectée à cet élément. Chacune des lignes reçoit sur son entrée d'élément un signal d'élément candidat, indiquant si l'élément correspondant est ou non un élément candidat à la sélection, et délivrant sur sa sortie d'élément un signal d'élément sélectionné indiquant si l'élément correspondant est ou non un élément sélectionné. La sélection est effectuée par une analyse colonne par colonne des éléments binaires codant lesdites valeurs numériques de sélection dans ladite matrice de sélection par priorité, la sélection effectuée pour une colonne de rang j conditionnant, pour chaque cellule (i, j) des M éléments, la transmission ou non d'un signal d'élément binaire retenu vers la cellule de rang j+1 du même élément. Ce signal d'élément binaire retenu correspond alors audit signal d'élément sélectionné, indiquant si l'élément correspondant est ou non un élément sélectionné, lorsque la cellule de rang j correspond au dernier bit de poids le plus faible.

Dans ce dispositif de sélection, pour effectuer le processus de sélection bit à bit dans les cellules successives des éléments de ladite matrice, les M cellules de chaque colonne de rang j, pour chacun des P bits, fournissent chacune un signal individuel de candidature de polarité binaire prioritaire, et ces M signaux individuels par colonne j alimentent une porte 'OU' à M entrées dont la sortie indique, sur une ligne commune par colonne j, l'existence ou non d'une polarité binaire prioritaire sur cette colonne j. Chaque cellule individuelle effectue alors la sélection de priorité, en déterminant si elle est encore sélectionnée en fonction d'une part de la polarité de son élément binaire de valeur numérique et d'autre part de l'existence ou non d'une polarité binaire prioritaire indiquée sur la ligne commune de cette colonne j.

L'architecture de ce dispositif connu est fondée sur une distribution de la logique de sélection dans chaque cellule de la matrice, ce qui conduit toujours à une spécialisation des cellules pour une application spécifique: par exemple, chaque cellule est spécialisée pour la recherche d'éléments ayant la plus grande valeur numérique, ou bien ayant la plus petite valeur numérique ; en outre, selon cette architecture connue, d'autres types de recherche d'éléments (par exemple ayant une valeur donnée, ayant une valeur inférieure ou bien supérieure à une valeur donnée, etc) nécessiteraient à chaque fois une matrice différente avec d'autres types de cellules spécialisées. Ce dispositif a donc pour inconvénient de ne pas être utilisable pour différentes applications alternativement. Il a en outre pour inconvénient de comporter un très grand nombre de liaisons individuelles entre les M cellules de chaque colonne j et la porte 'OU' associée par colonne j. La réalisation de ces interconnexions est donc complexe.

### 3 -objectifs de l'invention

L'invention a notamment pour objectif de pallier ces inconvénients de l'état de la technique.

Plus précisément, un objectif de l'invention est de fournir un dispositif de sélection par valeur numérique, qui présente un compromis optimal, ou à tout le moins meilleur que celui des techniques connues, entre la durée du cycle de fonctionnement, et la complexité de réalisation.

Un autre objectif de l'invention est de fournir un tel dispositif, qui puisse être utilisé dans de nombreux domaines et pour de nombreuses applications, et en particulier pour les systèmes de commutation asynchrone.

Un objectif particulier de l'invention est de fournir également un tel dispositif, qui puisse être utilisé pour des opérations de tri par classes d'éléments.

### 4 - présentation de l'invention

Ces objectifs, ainsi que d'autres qui apparaîtront plus clairement par la suite, sont atteints à l'aide d'un dispositif de sélection par valeur numérique de sélection d'au moins un élément parmi un sous-ensemble de C éléments candidats à la sélection, faisant partie d'un ensemble de M éléments possibles, une valeur numérique de sélection étant affectée à chacun desdits M éléments possibles, parmi N valeurs numériques de sélection possibles,
ledit dispositif mettant en oeuvre une matrice de sélection par priorité à deux dimensions comprenant M x P cellules de sélection organisées en M lignes et P colonnes, P étant le nombre d'éléments binaires, ou bits, nécessaires au codage de N valeurs distinctes, la cellule (i, j) correspondant à l'intersection d'une ligne de l'élément i et d'une colonne du bit j,
chacun desdits M éléments possibles correspondant à une desdites M lignes, à laquelle est associée la valeur numérique de sélection affectée à cet élément,
et chacune desdites lignes recevant sur son entrée d'élément un signal d'élément candidat, indiquant si l'élément correspondant est ou non un élément candidat à la sélection, et délivrant sur sa sortie d'élément un signal d'élément sélectionné indiquant si l'élément correspondant est ou non un élément sélectionné,
la sélection étant effectuée par une analyse colonne par colonne des éléments binaires codant lesdites valeurs numériques de sélection dans ladite matrice de sélection par priorité,
la sélection effectuée pour une colonne de rang j conditionnant, pour chaque cellule (i, j) des M éléments, la transmission ou non d'un signal d'élément binaire retenu vers la cellule de rang j+1 du même élément, ce signal correspondant alors audit signal d'élément sélectionné, indiquant si l'élément correspondant est ou non un élément sélectionné, lorsque la cellule de rang j correspond au dernier bit de poids le plus faible ;
**caractérisé** en ce qu'il comprend une unité de sélection raccordée à ladite matrice par P ensembles de lignes communes correspondant aux dites P colonnes de ladite matrice, cette unité commandant le processus de sélection bit à bit dans chaque cellule de ladite matrice, chaque cellule étant raccordée à l'ensemble de lignes communes de la colonne j correspondante,
et en ce que ladite unité de sélection fournit, sur au moins une ligne commune par colonne pour chacun des P bits, la polarité binaire sélectionnée résultant de la sélection qu'elle commande par colonne j.

Dans le dispositif ainsi caractérisé, la logique de sélection est, pour l'essentiel, située dans l'unité de sélection au lieu d'être distribuée dans les cellules. Ceci permet une architecture de cellule plus générique, donc une même matrice de sélection utilisable pour différentes applications, en modifiant seulement des moyens de commande de sélection situés dans l'unité de sélection.

Bien entendu, il est possible, et direct, d'inverser le rôle des colonnes et des lignes de la matrice de sélection par priorité, sans sortir du cadre de la présente invention. Les valeurs numériques de sélection peuvent être codées de toutes les manières adéquates. Selon un mode de réalisation préféré de l'invention, P=log₂N, lesdites valeurs numériques de sélection sont codées selon le codage binaire naturel.

De façon avantageuse, chacun desdits P ensembles de lignes communes comprend préférentiellement :
- deux lignes communes de candidature allant de ladite matrice à ladite unité de sélection, une première ligne commune de candidature indiquant la présence ou non d'une polarité binaire 1 candidate pour sélection parmi toutes les cellules i, j de la colonne correspondante j, et une seconde ligne commune de candidature indiquant la présence ou non d'une polarité binaire 0 candidate pour sélection parmi toutes les cellules (i, j) de la colonne correspondantej ; et
- deux lignes communes de sélection allant de l'unité de sélection à ladite matrice, une première ligne commune de sélection indiquant si la polarité binaire 1 est sélectionnée ou non parmi toutes les cellules (i, j) de la colonne correspondante j, et une seconde ligne commune de sélection indiquant si la polarité binaire 0 est sélectionnée ou non parmi toutes les cellules (i, j) de la colonne correspondante j.

De façon avantageuse, on prévoit que, dans ladite matrice, chaque cellule de sélection par priorité, correspondant à un élément particulier et à un élément binaire particulier, est raccordée :
- selon la dimension M, à la cellule précédente par une ligne entrante d'élément binaire candidat pour recevoir un signal d'entrée d'élément binaire retenu et à la cellule suivante par une ligne sortante d'élément binaire retenu pour transmettre un signal de sortie d'élément binaire retenu, chaque ligne entrante d'élément binaire candidat étant raccordée à la ligne sortante d'élément binaire retenu de la cellule précédente et chaque ligne sortante d'élément binaire retenu étant raccordée à la ligne entrante d'élément binaire candidat de la cellule suivante, et où la ligne entrante d'élément binaire candidat de la première cellule est raccordée à l'entrée de matrice de l'élément, qui reçoit ledit signal d'élément candidat, et la ligne sortante d'élément binaire retenu de la dernière cellule est raccordée à la sortie de matrice de l'élément, qui délivre ledit signal d'élément sélectionné ;
- et selon la dimension P, à l'ensemble de lignes communes relatif à l'élément binaire, qui comprend deux lignes communes de candidature interconnectant toutes les cellules relatives au même élément binaire ainsi que l'unité de sélection par priorité, et deux lignes communes de sélection provenant de l'unité de sélection par priorité, une première ligne commune de sélection indiquant si la polarité binaire 1 est sélectionnée ou non parmi toutes les cellules (i, j) de la colonne correspondante j, et la seconde ligne commune de sélection indiquant si la polarité binaire 0 est sélectionnée ou non parmi toutes les cellules (i, j) de la colonne correspondante j.

Selon un premier mode de réalisation de l'invention (dit "à valeur numérique implicite"), la valeur numérique de sélection affectée à au moins certains desdits éléments est fixe, et intégrée de façon implicite dans les cellules de chacun des éléments à valeur numérique fixe, chacune des cellules correspondantes étant alors différenciée en fonction de la polarité de l'élément binaire implicite dans ladite valeur numérique fixe.

Chacune desdites cellules des éléments à valeur numérique fixe peut alors comprendre avantageusement :
- une diode de découplage formant un "OU CABLE", dirigeant ledit signal d'entrée d'élément binaire retenu vers celle des deux lignes communes de candidature dont la polarité binaire correspond à celle de l'élément binaire implicite de la valeur numérique fixe de sélection affecté à cette cellule, indiquant si ainsi, sur les lignes communes de candidature, la polarité binaire de ce bit implicite, en activant la ligne commune de candidature appropriée lorsque ledit signal d'entrée d'élément binaire retenu est actif ;
- une porte "ET" délivrant ledit signal de sortie d'élément binaire retenu, et alimentée par ledit signal d'entrée d'élément binaire retenu et par celle des deux lignes communes de sélection dont la polarité binaire correspond à celle de l'élément binaire implicite affecté à cette cellule, indiquant si la polarité binaire correspondant à celle de cet élément binaire implicite est sélectionnée, de façon que ledit signal de sortie d'élément binaire retenu soit actif lorsque ledit signal d'entrée d'élément binaire retenu est actif et que simultanément un signal actif est reçu sur la ligne commune de sélection dont la polarité binaire correspond à celle de l'élément binaire implicite affecté à cette cellule.

Selon un second mode de réalisation de l'invention (dit "à valeur numérique explicite"), la valeur numérique de sélection affectée à au moins certains desdits éléments est explicite et mémorisée de façon dynamique ou semi-permanente.

On notera que les premier et second modes de réalisation peuvent être cumulées dans une même application.

Dans le cas du second mode de réalisation, ladite valeur numérique de sélection explicite peut avantageusement être mémorisée à l'intérieur de ladite matrice .

Selon une autre approche avantageuse, ladite valeur numérique de sélection explicite peut être mémorisée dans une mémoire externe, associée bit par bit à ladite matrice, chaque cellule de cette matrice recevant de ladite mémoire externe un élément binaire de la valeur numérique mémorisée.

De façon préférentielle, chacune desdites cellules comprend, dans le second mode de réalisation :
- deux portes "ET" à deux entrées, dont l'une des entrées est reliée audit signal d'entrée d'élément binaire retenu, la première porte "ET" correspondant à la polarité 0 ayant son autre entrée reliée à la polarité 0 de l'élément binaire explicite mémorisé, et la seconde porte "ET" correspondant à la polarité 1 ayant son autre entrée reliée à la polarité 1 de l'élément binaire explicite mémorisé ;
- deux diodes de découplage formant un "OU CABLE", une première diode dirigeant la sortie de ladite première porte "ET" vers la ligne commune de candidature de polarité binaire 0, et une seconde diode dirigeant la sortie de ladite seconde porte "ET" vers la ligne commune de candidature de polarité binaire 1, indiquant ainsi, sur ces lignes communes de candidature, la polarité binaire correspondant à l'élément binaire explicite mémorisé, en activant la ligne commune de candidature appropriée lorsque ledit signal d'entrée d'élément binaire retenu est actif ;
- et deux autres portes "ET" à deux entrées dont les sorties alimentent une porte "OU" délivrant ledit signal de sortie d'élément binaire retenu, la troisième porte "ET" correspondant à la polarité 0 ayant une entrée reliée à la sortie de ladite première porte "ET" et une autre entrée reliée à la ligne commune de sélection de polarité 0, et la quatrième porte "ET" correspondant à la polarité 1 ayant une entrée reliée à la sortie de ladite seconde porte "ET" et une autre entrée reliée à l'autre ligne commune de sélection de polarité 1, indiquant si la polarité binaire correspondant à celle de l'élément binaire explicite mémorisé est sélectionnée, de façon que ledit signal de sortie d'élément binaire retenu soit actif lorsque ledit signal d'entrée d'élément binaire retenu est actif et que simultanément un signal actif est reçu sur la ligne commune de sélection dont la polarité binaire correspond à celle de l'élément binaire explicite mémorisé correspondant à cette cellule.

Selon une application de l'invention, le dispositif de sélection met en oeuvre une recherche de la plus grande valeur numérique de sélection. Ladite unité de sélection effectue alors préférentiellement les opérations suivantes, pour chacun desdits P éléments binaires :
- si un signal actif est reçu sur la ligne commune de candidature correspondant à un élément binaire candidat de polarité 1, activation de la ligne commune de sélection correspondant à un élément binaire sélectionné de polarité 1 ;
- sinon, si un signal actif est reçu sur la ligne commune de candidature correspondant à un élément binaire candidat de polarité 0, activation de la ligne commune de sélection correspondant à un élément binaire sélectionné de polarité 0.

Selon une autre application, il met en oeuvre une recherche de plus petite valeur numérique de sélection. Dans ce cas, ladite unité de sélection effectue avantageusement les opérations suivantes, pour chacun desdits P éléments binaires :
- si un signal actif est reçu sur la ligne commune de candidature correspondant à un élément binaire candidat de polarité 0, activation de la ligne commune de sélection correspondant à un élément binaire sélectionné de polarité 0 ;
- sinon, si un signal actif est reçu sur la ligne commune de candidature correspondant à un élément binaire candidat de polarité 1, activation de la ligne commune de sélection correspondant à un élément binaire sélectionné de polarité 1.

Selon encore un autre aspect, le dispositif de sélection peut effectuer dans le dispositif une opération de recherche des éléments ayant une valeur numérique donnée parmi les C éléments candidats pour sélection faisant partie des M éléments de la matrice.

Dans ce cas, il comprend en outre, de façon avantageuse, une unité d'identification d'éléments par valeur numérique de sélection donnée connectée à ladite matrice par P couples de lignes communes de sélection allant de ladite unité d'identification à ladite matrice, chaque couple de lignes comprenant une première ligne commune de sélection indiquant si la polarité binaire 1 est sélectionnée ou non pour la colonne correspondante j, et une seconde ligne commune de sélection indiquant si la polarité binaire 0 est sélectionnée ou non pour la colonne correspondante j,
et ladite unité d'identification d'éléments :
- reçoit le code de la valeur numérique de sélection recherchée,
- et positionne, pour chaque colonne j, lesdites lignes communes de sélection en fonction de la polarité des bits de la valeur numérique donnée recherchée parmi les C éléments candidats pour sélection.

De façon préférentielle, dans ce cas, ladite unité d'identification d'éléments par valeur numérique de sélection donnée délivre également un signal de présence d'au moins un élément identifié, et :
- est connectée à la matrice par P couples de lignes communes de candidature allant de la matrice à ladite unité d'identification, une première ligne commune de candidature indiquant la présence ou non d'une polarité binaire 1 candidate pour sélection parmi toutes les cellules i, j de la colonne correspondante j, et la seconde ligne commune de candidature indiquant la présence ou non d'une polarité binaire 0 candidate pour sélection parmi toutes les cellules i, j de la colonne correspondantej ; et
- détecte la présence ou l'absence d'éléments recherchés en effectuant une comparaison bit à bit entre les codes des éléments candidats à la sélection qu'elle reçoit sur lesdites lignes communes de candidature et le code de la valeur numérique de sélection donnée recherchée parmi les C éléments candidats pour sélection.

D'autres modes de réalisation particuliers permettent notamment les applications suivantes :
1) La recherche d'éléments ayant une valeur numérique supérieure ou égale à une valeur numérique donnée dite de seuil plancher .
2) La recherche d'éléments ayant une valeur numérique inférieure ou égale à une valeur numérique donnée dite de seuil plafond .
3) La recherche d'éléments ayant la plus grande valeur numérique qui soit supérieure ou égale à une valeur numérique donnée dite de seuil plancher.
4) La recherche d'éléments ayant la plus grande valeur numérique qui soit inférieure ou égale à une valeur numérique donnée dite de seuil plafond .
5) La recherche d'éléments ayant la plus petite valeur numérique qui soit supérieure ou égale à une valeur numérique donnée dite de seuil plancher.
6) La recherche d'éléments ayant la plus petite valeur numérique qui soit inférieure ou égale à une valeur numérique donnée dite de seuil plafond.

### 5 - Liste des figures

D'autres caractéristiques et avantages de l'invention apparaîtront plus clairement à la lecture de la description suivante de plusieurs modes de réalisation, donné à titre illustratif et non limitatif et des dessins annexés parmi lesquels :
- la figure 1 illustre la présentation sous forme de tableaux de valeurs numériques des éléments à sélectionner ou trier selon l'invention ;
- la figure 2 présente un premier mode de réalisation de dispositif de sélection par valeur numérique selon l'invention ;
- la figure 3 illustre une cellule de sélection par valeur numérique PSC du dispositif de la figure 2 ;
- la figure 4 représente une matrice PSA, formée de M x P cellules PSC telle qu'illustrées en figure 3 ;
- les figures 5A et 5B illustrent deux modes de réalisation d'une cellule PSC à valeur numérique « implicite », respectivement lorsque le bit implicite est de valeur 0 et lorsque le bit implicite est de valeur 1 ;
- la figure 6 représente une cellule PSC à valeur numérique « explicite » mémorisée au sein de la cellule ;
- la figure 7 illustre un autre mode de réalisation d'une cellule PSC à valeur numérique « explicite » fournie à cette cellule par une mémoire externe ;
- les figures 8 et 9 présentent deux types d'unités de sélection par valeur numérique pour le dispositif de sélection de la figure 2, selon que la sélection se fait par plus grande ou plus petite valeur numérique ;

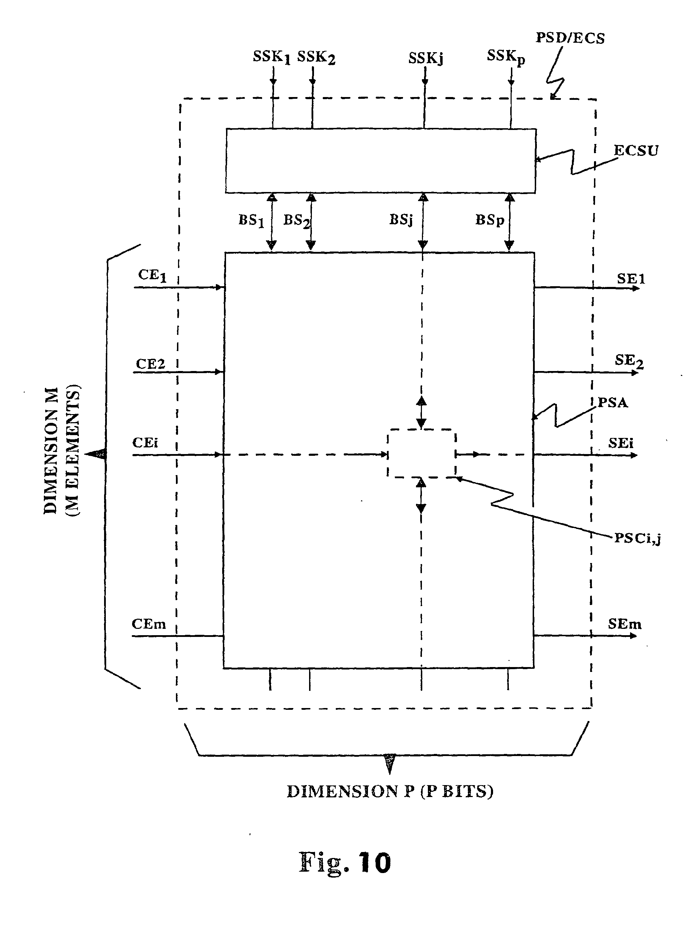

- la figure 10 illustre un dispositif de sélection amélioré PSD, avec tri par classes d'éléments ;

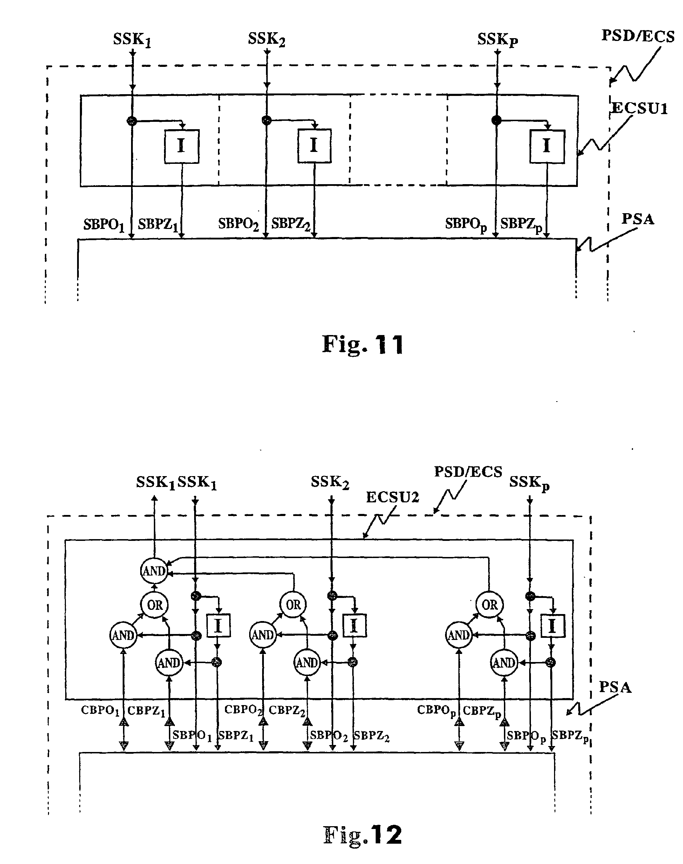

- les figures 11 et 12 illustrent deux modes de réalisation de l'unité de tri par classe d'éléments (ECSU) pour le dispositif PSD de la figure 10.

### 6 - description de modes de réalisation de l'invention

### 6.1- introduction

Par la suite, on présente divers modes de réalisation de sélection d'éléments par valeur numérique : d'abord le mode de sélection par rang d'élément, puis le mode de tri par classe d'éléments.

On peut distinguer tout d'abord deux types d'applications dites "de base" suivant la nature du paramètre (de rang ou de tri) associé à chaque élément, à savoir une valeur numérique de paramètre "implicite" (donc fixe) ou "explicite" (donc mémorisée et potentiellement variable).

On présente ci-après quelques exemples d'applications pratiques dans chaque type d'applications de base.

### 6.1.1 paramètres implicites

Pour les paramètres "implicites", on peut envisager divers types d'associations "régulières" (c'est-à-dire algorithmiques) entre les valeurs de paramètres et le nombre d'éléments "non réguliers" ou d'associations "non régulières" (prédéfini(e)s de manière arbitraire). La valeur numérique du paramètre implicite d'un élément est fixée par construction dans le dispositif.

Un exemple courant d'association régulière est lorsque le paramètre de rang est implicitement identique au numéro d'élément proprement dit. On trouve parmi ces opérations possibles l'opération classique consistant à trouver le premier (FFO = "Find First One") élément candidat dans un ensemble ordonné d'éléments.

Parmi les exemples types où la valeur de paramètre définie implicitement diffère du numéro d'élément, on trouve le traitement de listes d'éléments en fonction des paramètres de sélection (rang) de priorité et/ou de clé de tri qui leur sont associés (c'est-à-dire une liste de C éléments candidats parmi M éléments possibles).

### 6.1.2 paramètres explicites

Pour les paramètres "explicites", la gamme des applications est encore plus vaste étant donné que n'importe quelle valeur numérique de paramètre peut être attribuée à n'importe quel moment à chaque élément (la valeur numérique du paramètre explicite d'un élément étant mémorisée et accessible). Voici quelques exemples d'utilisation de données de paramètres explicitement variables :
- modification de façon semi-permanente du rôle relatif de chaque élément (par exemple la priorité relative des alarmes) en fonction du type de phase de traitement ;
- définition de manière dynamique du paramètre de rang ou de tri instantané d'un élément (par exemple un "temps de départ planifié" associé à une cellule actuellement mémorisée dans un emplacement donné d'une mémoire tampon, l'adresse de cet emplacement étant utilisé pour désigner une cellule en tant qu'élément dans le dispositif).

### 6.1.3 modes de réalisation décrits

Les modes de réalisation proposés ci-après sont à chaque fois décrits pour ces deux cas d'applications de base, c'est-à-dire avec une valeur numérique "implicite" ou "explicite".

En outre, en ce qui concerne les opérations de sélection par rang, les solutions proposées comprennent systématiquement deux types d'opérations possibles, à savoir la sélection des éléments ayant la plus grande ou la plus petite valeur numérique (de paramètre de rang).

### 6.1.4 glossaire

Pour faciliter la lecture de la présente demande, on affecte aux différents éléments, lignes et signaux discutés un acronyme. La première fois qu'un terme apparaît, on précise son acronyme, ainsi qu'une traduction anglaise. On les récapitule ci-après :
- BP: Polarité de bit
- BR: signal d'élément binaire retenu
- BS: ensemble de lignes communes
- CBP: ligne commune de candidature
- CBPO: ligne commune de candidature de la polarité un
- CBPZ: ligne commune de candidature de la polarité zéro
- EBC: ligne entrante d'élément binaire candidat
- EC: signal entrant d'élément candidat
- ECS: tri par classe d'éléments
- ECSU: unité de tri par classe d'éléments
- EE: entrée d'élément d'une matrice PSA
- ES: signal sortant d'élément sélectionné
- LSB: bit de poids le plus faible
- MSB: bit de poids le plus fort
- PB: bit de priorité mémorisé
- PSA: matrice de sélection par valeur numérique
- PSC: cellule de sélection par valeur numérique
- PSD: dispositif de sélection par valeur numérique
- PSU: unité de sélection par valeur numérique
- SBP: ligne commune de sélection
- SBPO: ligne commune de sélection de la polarité un
- SBPZ: ligne commune de sélection de la polarité zéro
- SBS: ligne sortante d'élément binaire retenu
- SE: sortie d'élément d'une matrice PSA
- SEP: signal de présence d'éléments triés
- SSK: valeur numérique de clé de tri recherchée

### 6.2 - principe de sélection par valeur numérique de rang

Dans la suite de la description, on suppose un exemple classique d'application où la valeur numérique du rang associé à élément représente le niveau de priorité de cet élément.

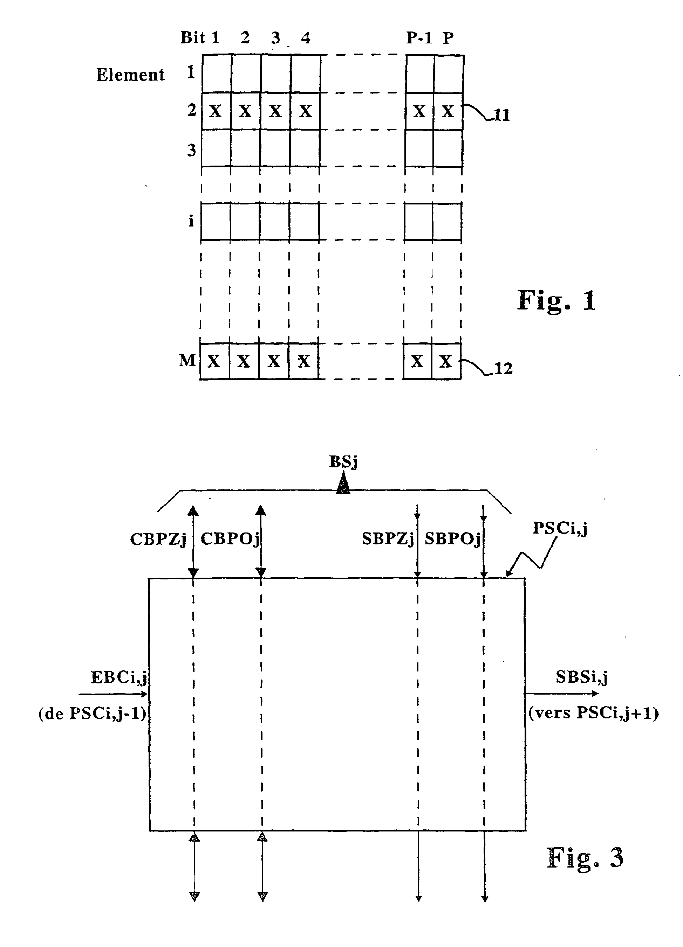

Le mode de réalisation décrit se base sur les principes et sur l'algorithme de sélection par valeur numérique de rang (c'est-à-dire de niveau de priorité dans l'exemple décrit) suivant :
- N niveaux de priorité distincts sont codés avec P = log₂ N bits et classés de 1 à n, dont la valeur numérique correspond respectivement à tous les zéros et à tous les uns ;
- Deux protocoles de sélection par priorité, à savoir la sélection par niveau de priorité supérieur ou par niveau de priorité inférieur, (et on verra qu'ils débouchent pratiquement sur la même solution) ; en fait, ces deux protocoles de sélection par priorité peuvent être équivalents en principe selon que l'on utilise un codage direct ou en polarité inversée (par exemple, il est connu qu'une sélection de plus grande valeur numérique en codage direct est équivalente à une sélection de plus petite valeur numérique en codage en polarité inversée);
- Si l'on considère un ensemble de M éléments possibles pouvant être traités par un dispositif de sélection par valeur numérique [ici de niveau de priorité] (PSD), M représentant la capacité d'analyse dispositif, parmi lesquels C éléments (0 ≤ C ≤ M) sont réellement candidats à une à un instant donné pour participer à une opération de sélection, C représentant l'ensemble dynamique des éléments candidats à la sélection. Chacun des C éléments étant associé à un niveau de priorité L (1 ≤ L ≤ N), on peut représenter cela à l'aide d'une structure à deux dimensions, en disposant ces C valeurs numériques de niveau de priorité dans un tableau de M rangées (pour M éléments) et P colonnes (pour P bits codant la valeur numérique du niveau de priorité) comme sur la **figure** 1. On notera que pour les (M - C) éléments (11, 12) qui ne sont pas candidats à la sélection, il est indifférent de supposer qu'ils aient ou non un niveau de priorité associé (d'où la valeur numérique XX ... X dans leur rangée).
- Puis, pour les valeurs numériques binaires des niveaux de priorité des C éléments, l'algorithme consiste à effectuer verticalement une sélection bit par bit en commençant par le bit de poids le plus fort (MSB), c'est-à-dire le bit 1, puis en passant au bit suivant (bit 2), etc., jusqu'au bit de poids le plus faible (LSB), c'est-à-dire le bit p, comme suit :
   - Dans le cas de la sélection du niveau de priorité "supérieur",
      a) On examine la première colonne de bits de poids le plus fort MSB ; si un bit d'au moins d'élément candidat est à 1, on ne retient que le ou les éléments candidats ayant ce premier bit à 1; sinon on retient les éléments candidats ayant un premier bit à zéro.
      b) On examine ensuite la deuxième colonne de bit 2 où seuls le ou les éléments retenus au paragraphe a) ci-dessus sont candidats ; la même sélection s'applique pour le bit 2 : si au moins un bit est à 1, on ne retient que le ou les éléments candidats restants ayant le deuxième bit à 1; sinon on retient le ou les éléments candidats ayant le deuxième bit à zéro.
      c) Et ainsi de suite: on effectue la même opération de sélection bit par bit jusqu'au dernier bit p. Ensuite, le ou les éléments candidats restants sont sélectionnés comme ayant le code de niveau de priorité le plus élevé (plusieurs éléments peuvent avoir le même niveau de priorité et peuvent donc être sélectionnés ensemble lorsque ce niveau est le niveau supérieur).
   - Dans le cas de la sélection du niveau de priorité "inférieur"
      L'algorithme est symétrique, en remplaçant 1 par 0 et vice versa.
      Le processus de sélection bit par bit est alors le suivant : "Si au moins un bit est à 0, on ne retient que le ou les éléments candidats restants ayant ce bit à 0, sinon, on retient le ou les éléments candidats restants ayant ce bit à 1".

Pour illustrer ce principe, on considère un exemple (de taille réduite) tel qu'il est représenté sur le tableau 1 avec M = 8 et C = 5, et l'on applique une sélection de niveau de priorité "inférieur" sur des valeurs numériques de niveau de priorité à 4 bits :

| M = | Candidat ou non ? = | Niveau de priorité = |
|---|---|---|
| 1 | Oui | 6 |
| 2 | Non | [15] |
| 3 | Oui | 3 |
| 4 | Oui | 12 |
| 5 | Non | [2] |
| 6 | Oui | 3 |
| 7 | Non | [8] |
| 8 | Oui | 7 |

**Tableau 1 - Exemple d'opération de sélection par priorité inférieure**

| B: | 1 | 2 | 3 | P = 4 | Sélectionné |
|---|---|---|---|---|---|
| Elément: | | | | | |
| 1 | 0 | 1 | (0) | (1) | |
| [2] | [1] | [1] | [1] | [0] | |
| 3 | 0 | 0 | 1 | 0 | X |
| 4 | 1 | (0) | (1) | (0) | |
| [5] | [0] | [0] | [0] | [1] | |
| 6 | 0 | 0 | 1 | 0 | X |
| [7] | [0] | [1] | [1] | [1] | |
| m=8 | 0 | 1 | (1) | (0) | |

Les quatre opérations de sélection bit par bit sont exécutées comme suit :
1. Pour le bit 1, quatre éléments (1, 3, 6 et 8) sont retenus étant donné que leur premier bit est à 0 ;
2. Pour le bit 2, seuls deux des éléments précédemment retenus sont retenus étant donné que leur deuxième bit est à 0, à savoir les éléments 3 et 6.
3. Pour le bit 3, les éléments précédemment retenus (3 et 6) sont encore retenus étant donné que leur troisième bit est à 1 et qu'aucun élément retenu n'a un troisième bit à 0;
4. Pour le bit 4, les deux éléments précédemment retenus (3 et 6) sont encore retenus étant donné que leur quatrième bit est à 0, et sont tous deux finalement sélectionnés comme ayant la plus petite valeur numérique de niveau de priorité (à savoir la valeur 3) parmi les 5 éléments candidats.

On peut en outre remarquer que la symétrie entre sélection par priorité "supérieure" et "inférieure" s'applique également en termes d'application (c'est-à-dire d'utilisation du dispositif de sélection PSD). En effet, afin de trouver un niveau de priorité supérieur, on peut effectuer soit une sélection par priorité supérieure, soit une sélection par priorité inférieure sur leurs codes binaires complémentaires (et vice versa).

### 6.3 - dispositif de sélection par niveau de priorité (PSD)

Selon le principe décrit ci-dessus, présenté sous forme d'un tableau des M valeurs numériques de niveau de priorité des éléments reflétant une structure à deux dimensions (M éléments x P bits) pour le traitement des niveaux de priorité, l'objectif est de réaliser un compromis optimal entre complexité et temps de réponse conduisant à une distribution (quasi) optimale du minimum d'informations requises dans cette structure M x P (c'est-à-dire, pour chaque bit individuel de la valeur numérique de niveau de priorité d'un élément, d'une part la polarité de ce bit et d'autre part la condition que ce bit est retenu ou non au cours du processus de sélection), et au maintien de la centralisation de certaines fonctions minimales (par exemple pour effectuer l'opération de sélection suivant l'algorithme de recherche spécifique).

L'architecture du dispositif de sélection par priorité (PSD) proposé permet de définir une matrice de sélection générique composée de cellules non spécialisées, qui offre donc plus de souplesse pour effectuer différents types d'opérations de sélection.

### 6.3.1 - Description générale du dispositif PSD proposé

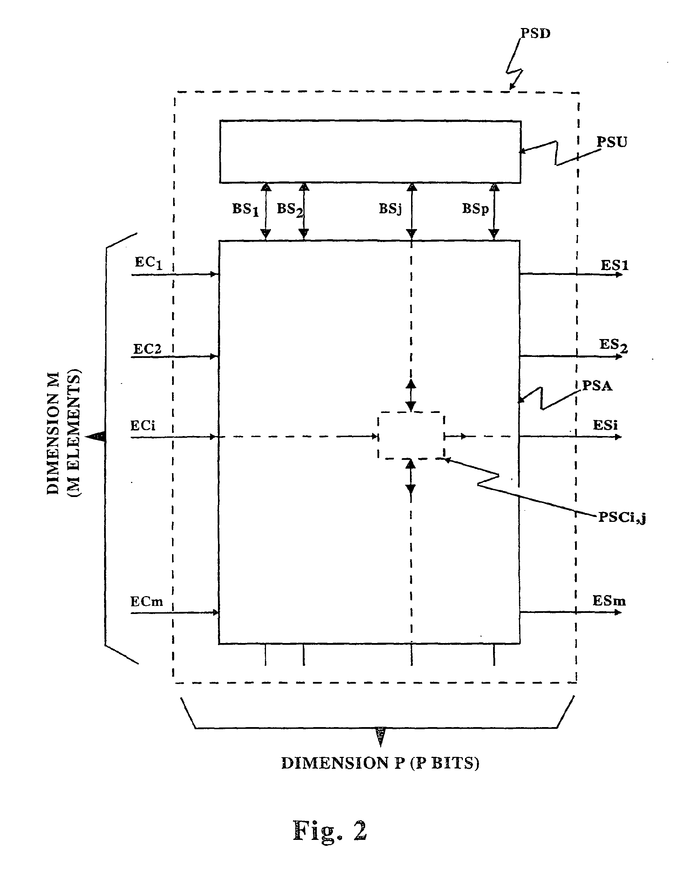

L'architecture générale du dispositif PSD peut être illustrée comme sur la **figure** 2, c'est-à-dire avec :
- une matrice de sélection par priorité (PSA = "Priority Selection Array") à deux dimensions (M x P), comportant :
   - M x P cellules de sélection par priorité (PSC = "Priority Selection Cell"),
   - M entrées d'élément EE ("Element Input") et M sorties d'élément SE ("Element Output") selon la dimension M (c'est-à-dire relatives à M éléments), chaque entrée EE pouvant recevoir un signal d'élément candidat EC ("Candidate Element") et chaque sortie SE pouvant délivrer un signal d'élément sélectionné ES ("Selected Element").
   - P ensembles de lignes communes, ou de bus (BS = "Bus System") selon la dimension P (c'est-à-dire relatifs aux P bits), se raccordant à une unité de sélection par priorité (PSU = "Priority Selection Unit") [par la suite, on désigne parfois une ligne commune par le terme ligne de bus].
- et une unité de sélection par priorité (PSU) commandant le processus de sélection bit par bit.

En outre, chaque cellule PSC de la matrice PSA est définie comme sur la **figure** 3, c'est-à-dire avec :
- une ligne entrante de bit (ou élément binaire) candidat EBC ("Candidate Bit Input") et une ligne sortante de bit retenu SBS ("Selected Bit Output") selon la dimension M. Pour une cellule PSCx,j relative à un bit de rang j, le signal élément binaire retenu BRx,j/j+1 ("Retained Bit") que cette cellule élabore, sort sur sa ligne SBSx,j, et entre sur la ligne EBCx, j+1 de la cellule PSCx, j+1 du bit de rang suivant j+1.
- et quatre lignes communes dans le système de bus BS selon la dimension P, soit pour chaque bit j, deux lignes communes de candidature (CBPZj, CBPOj) allant de la matrice PSA à l'unité PSU et indiquant respectivement la candidature de polarité zéro et la candidature de polarité un du bit j, et deux lignes communes de sélection (SBPZj, SBPOj) allant de l'unité PSU à la matrice PSA, et indiquant respectivement la sélection de polarité zéro et la sélection de polarité un du bit j.

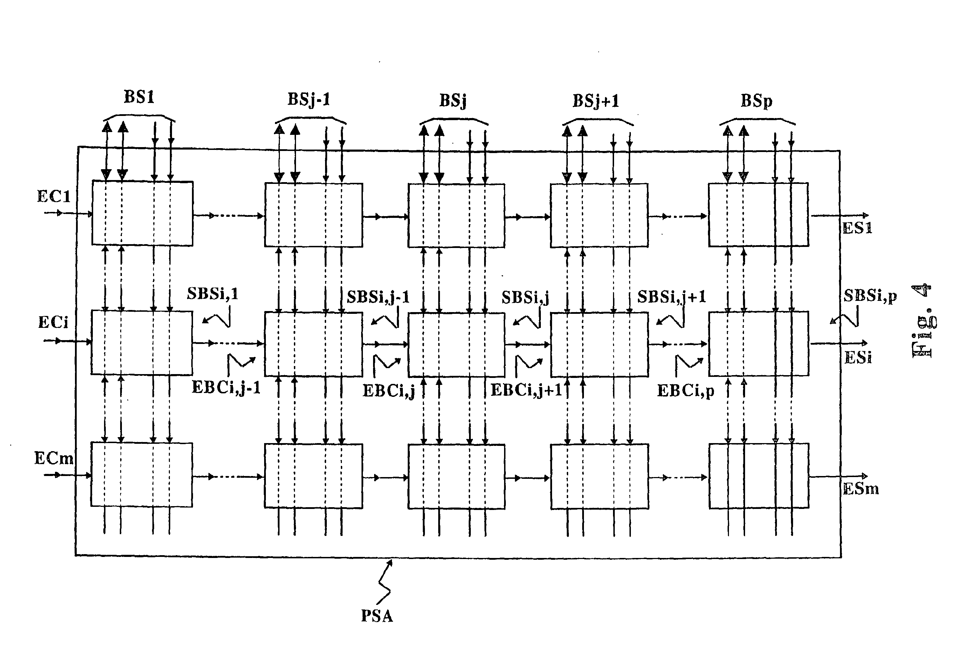

Les M x P cellules PSC de la matrice PSA sont interconnectées de la manière indiquée sur la **figure** 4. Elles sont indicées i, j ; de même que les signaux et lignes correspondants.

### 6.3.2 - Aspects complémentaires pour le dispositif PSD

Les principaux aspects complémentaires décrits ci-après concernent :
- Les modes de réalisation possibles pour les cellules PSC en fonction du "type d'application de base" ;
- Les modes de réalisation possibles pour l'unité PSU en fonction du type d'algorithme de sélection.

### 6.3.2.1 - Cellules PSC

Comme indiqué précédemment, on propose ci-après deux "applications de base", à savoir :
- Application A, dans laquelle un niveau de priorité fixe est "implicitement" associé à chacun des M éléments ;
- Application B, dans laquelle un niveau de priorité variable est "explicitement" associé à chacun des M éléments.

Compte tenu de la compatibilité entre les cellules PSC des applications A et B, on verra en outre qu'une autre application C intermédiaire est également concevable, dans laquelle une partie des M éléments ont un niveau de priorité fixe (implicite) et d'autres éléments ont un niveau de priorité variable (explicite). De plus, une autre application D est également possible, dans laquelle les éléments ont des codes de niveau de priorité "mixte", c'est-à-dire dans laquelle une partie des bits sont fixes ("implicites") et d'autres sont variables ("explicites").

### application A

Dans l'application A, la valeur numérique de niveau de priorité, associée de façon fixe à chaque élément, est dit "implicite" car aucune donnée explicite n'est utilisée pour désigner ce niveau de priorité. Dans ce cas, la valeur numérique associée à un élément est intégrée de manière statique dans la réalisation des cellules PSC de la matrice PSA du dispositif.

Aucune hypothèse particulière n'est faite : en effet, en ce qui concerne le type d'association entre les éléments et les niveaux de priorité, elle peut être soit "régulière" (c'est-à-dire basée sur un algorithme), soit "non régulière".

Voici quelques exemples d'associations algorithmiques :
- Niveau de priorité 1 ou 2 en fonction de la parité impaire/paire du numéro d'élément ;
- Niveau de priorité 1 ou 2 en fonction d'un fractionnement à seuil des M éléments en deux sous-ensembles adjacents d'éléments ;
- Niveau de priorité 1, 2, ... N identique au numéro d'élément lorsque M = N.

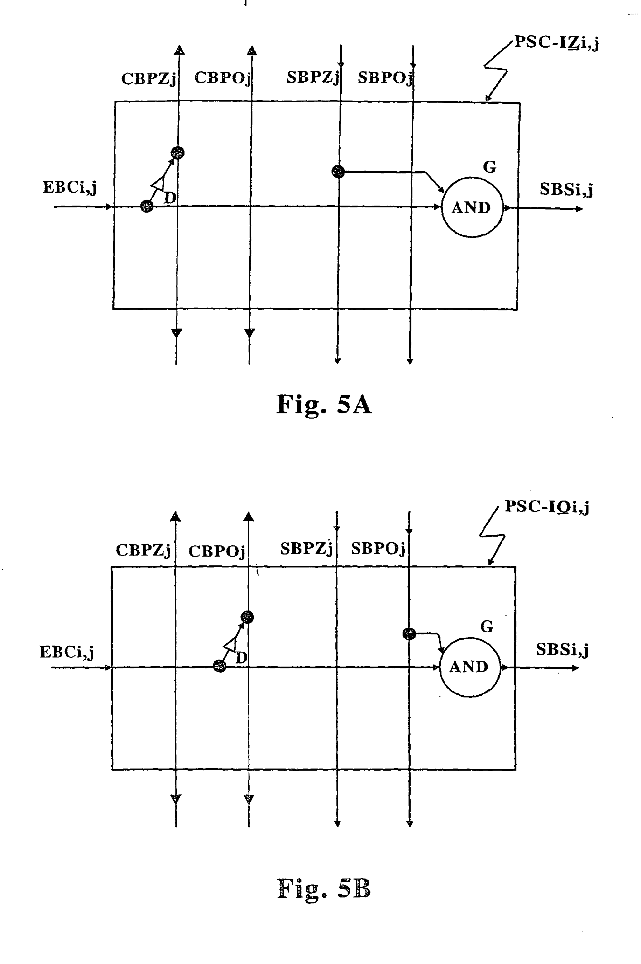

Dans l'application A, la valeur numérique de niveau de priorité de chaque élément est donc câblée dans les cellules du dispositif réalisé, la solution utilisée consistant à fixer dans la cellule correspondante proprement dite la polarité de bit de la valeur numérique du niveau de priorité implicite. Ainsi, comme l'illustrent les **figures** 5A et 5B**,** on prévoit deux réalisations différentes pour une cellule PSC-I ("I" pour niveau de priorité "implicite"), à savoir : une cellule PSC-IZ lorsque le bit correspondant de valeur numérique de niveau de priorité est fixé à zéro, et une cellule PSC-IO lorsque le bit est fixé à un.

Pour chacun des P bits, une cellule PSC-IZ (ou PSC-IO) pour l'application A fonctionne comme suit :
- Un signal entrant d'élément binaire retenu BR actif (lorsqu'il est à un) sur la ligne entrante de bit candidat EBC alimente la ligne commune de candidature CPBZ (ou CBPO) en "OU CABLE" par l'intermédiaire d'une diode de découplage D, activant ainsi la ligne de bus de candidature appropriée vers l'unité PSU ;
- En fonction des signaux actifs ou non qu'elle détecte sur les lignes communes de candidature CPBZ et CBPO, l'unité PSU active la ligne commune de sélection SBPZ ou SBPO selon la polarité du bit sélectionné ; si la cellule PSC-I détecte un signal actif sur une ligne commune de sélection de la même polarité que celle de son bit implicite et si la cellule considérée est activée par le signal entrant BR sur sa ligne entrante EBC, la porte ET G génère, sur sa ligne sortante SBS, un signal sortant BR actif (c'est-à-dire à un) indiquant que ce bit de cet élément a été retenu, ce qui signifie, à ce stade (c'est-à-dire jusqu'à ce bit inclus), que l'élément fait encore partie des éléments retenus dans le processus de sélection.
- A l'inverse, le signal sortant BR élaboré par la cellule PSC-I n'est pas actif (c'est-à-dire à zéro) sur sa ligne sortante SBS lorsque le signal entrant BR n'est pas actif, ou bien lorsqu'il est actif mais que la polarité de bit sélectionné reçue de l'unité PSU ne correspond pas à celle du bit implicite fixée dans la cellule PSC-I.

### application B

Dans l'application B, la valeur numérique de niveau de priorité associée (de façon dynamique ou semi-permanente) à chaque élément est dit "explicite" car on utilise des données explicites pour désigner ce niveau de priorité. Dans ce cas, la valeur numérique du niveau de priorité explicite d'un élément peut être mémorisée soit au sein du PSD proprement dit (plus particulièrement dans les P cellules PSC de cet élément au sein de la matrice PSA), soit dans une mémoire adjacente à l'extérieur du PSD (auquel cas la polarité de chaque bit de la valeur numérique est transmise de cette mémoire externe à la cellule PSC correspondante de cet élément).

### 1) Code de niveau de priorité explicite au sein du dispositif (version B1) :

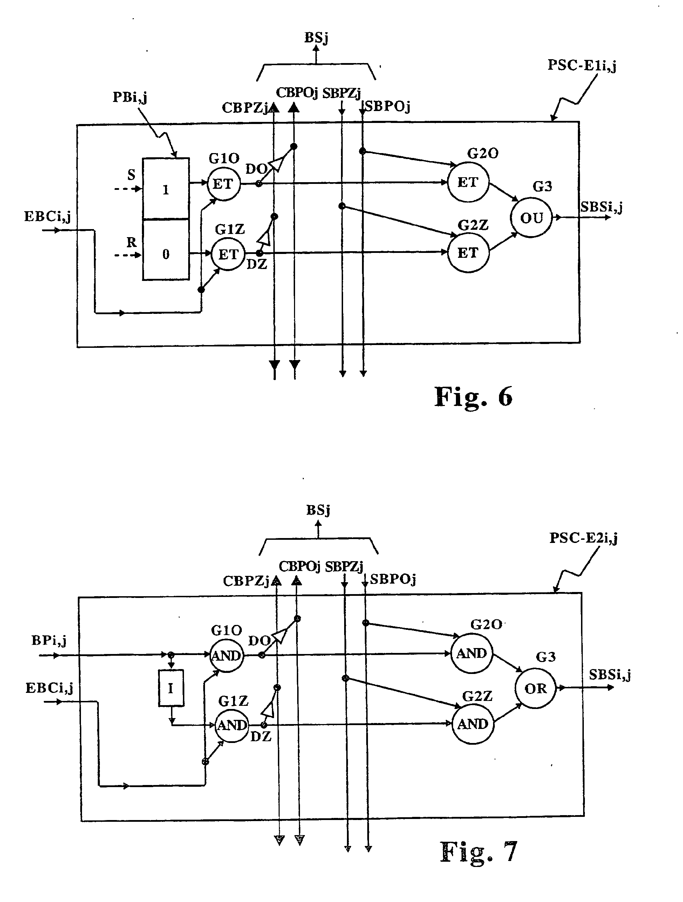

Une première solution consiste à intégrer chaque bit de mémoire de la valeur numérique de niveau de priorité associée (c'est-à-dire le bit de priorité PB) dans la cellule apparentée PSC-E1 ("1"pour version B1, "E" pour bit "explicite") comme on le voit sur la **figure** 6. Dans ce cas, la matrice PSA intègre également la fonction de mémoire pour enregistrer les valeurs numériques de niveau de priorité associées aux divers éléments. Ainsi, dans la présente version de l'application B, pour un élément donné I, la valeur numérique de niveau de priorité est inscrite en utilisant la matrice PSA comme mémoire classique de M rangées de P bits, c'est-à-dire sélectionnant la rangée I et enregistrant les P bits de la valeur numérique requise, chaque point de mémoire PB des cellules PSC-E sélectionnées étant mis à 0 ou 1 au moyen de signaux d'accès d'écriture "S" ou "R" (on peut utiliser un système classique quelconque pour effectuer cette opération d'écriture dans la matrice PSA utilisée comme mémoire).

Pour chacun des P bits, une cellule PSC-E1 pour l'application B1 fonctionne comme suit pour une opération de sélection par priorité :
- Un signal entrant d'élément binaire retenu BR actif (lorsqu'il est à un) sur la ligne entrante de bit candidat EBC de la cellule autorise l'émission d'un signal actif (à 1) sur la ligne commune de candidature CPBZ ou CBPO en fonction de la polarité de bit mémorisée dans le point de mémoire du bit de priorité (PB) par l'intermédiaire de la porte ET G1Z ou G1O et par l'intermédiaire d'une diode de découplage DZ ou DO, en activant ainsi la ligne commune appropriée de candidature CBPZ ou CBPO vers l'unité PSU ;
- En fonction des signaux actifs ou non qu'elle détecte sur les lignes communes de candidature CPBZ et CBPO, l'unité PSU active la ligne commune de sélection SBPZ ou SBPO selon la polarité de bit sélectionné ; dans la cellule, si la ligne commune SBPZ (ou SBPO) est active, la porte ET G2Z (ou G2O) délivre un 1 lorsque la polarité du bit sélectionné correspond à celle du bit explicite mémorisé dans la cellule et si cette dernière est activée par le signal entrant BR ; dans ce cas, la porte OU G3 délivre, sur la ligne sortante SBS de la cellule, un signal sortant BR actif (à un) indiquant que ce bit de cet élément a été retenu, ce qui signifie qu'à ce stade l'élément fait encore partie des éléments retenus dans le processus de sélection.
- A l'inverse, le signal sortant BR élaboré par la cellule n'est pas activé (c'est-à-dire à zéro) sur sa ligne sortante SBS lorsque le signal entrant BR n'est pas actif, ou bien lorsqu'il est actif mais que la polarité de bit sélectionné reçue de l'unité PSU ne correspond pas à celle du bit explicite mémorisée dans le point de mémoire PB de la cellule.

### 2) Code de niveau de priorité explicite à l'extérieur du dispositif (version B2)

Pour stocker les valeurs numériques de niveau de priorité des M éléments, cette deuxième solution propose la mise en oeuvre d'une mémoire externe qui est raccordée (c'est-à-dire, dans le présent document, associée bit par bit) à la matrice PSA par au moins une ligne de transmission d'un signal de polarité de bit BP (= "Bit Polarity"), de sorte que chaque cellule PSC-E2 reçoit sa polarité de bit appropriée depuis la mémoire externe, comme l'illustre la **figure** 7.
Alors, une cellule PSC-E2 pour l'application B2 fonctionne comme une cellule PSC-E1 pour l'application B1, si ce n'est que les deux polarités de bit alimentant les portes G1O et G1Z proviennent maintenant du signal entrant BP (l'un directement et l'autre par l'intermédiaire de l'inverseur I), et non plus d'un point de mémoire PB local comme dans le cas précédent.

### - Applications mixtes (C et D) :

A partir de la description précédente de divers types de cellules PSC, on comprend qu'on peut les mélanger de manière compatible dans une réalisation particulière de dispositif PSD pour des applications C ou D telles que définies précédemment.

### 6.3.2.2 - Unité de sélection par priorité (PSU) pour le dispositif PSD

Deux types d'unité PSU de base sont décrits ci-après, respectivement pour l'algorithme de sélection par priorité "supérieure" ou par priorité "inférieure", c'est-à-dire pour sélectionner en fait le ou les éléments ayant la plus grande ou la plus petite valeur numérique de niveau de priorité.

Comme cela a déjà été mentionné, ce qui importe pour le dispositif de sélection sont d'une part les valeurs numériques réelles qu'il traite et d'autre part le mode de sélection (plus grande ou plus petite valeur) qu'il utilise, sachant que l'interprétation de ces valeurs en termes de priorités fonctionnellement supérieures ou inférieures reste ouverte et laissée à l'application, ceci n'ayant pas incidence sur le fonctionnement du dispositif PSD proprement dit.

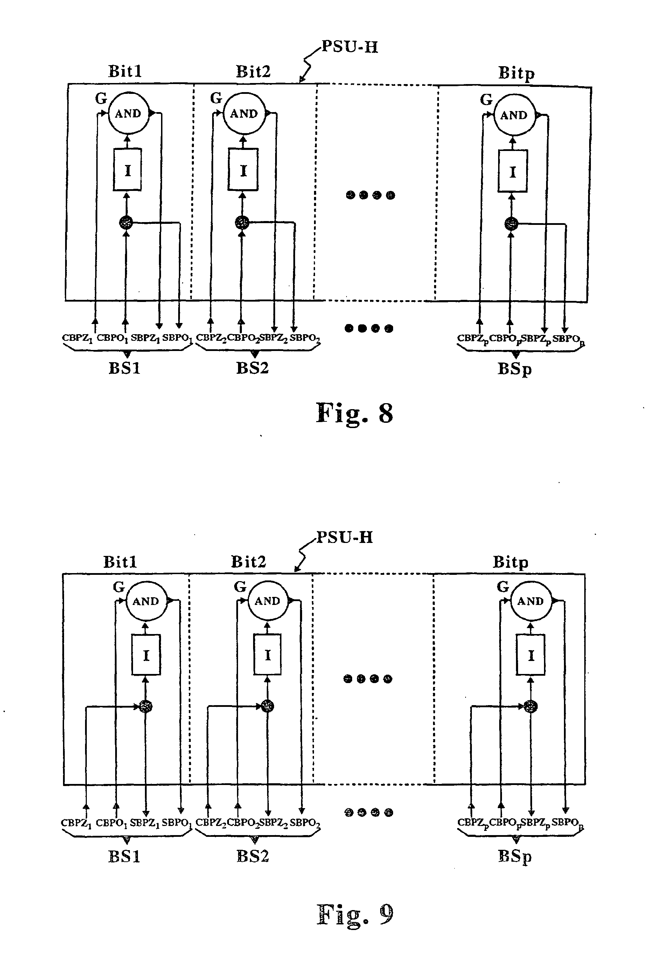

Pour la sélection par priorité "supérieure", pour chacun des P bits, l'unité PSU émet un 1 sur une des 2 lignes de bus (ou lignes communes) de sélection comme suit (voir la **figure** 8) :
- Si l'unité PSU reçoit un 1 sur la ligne commune de candidature CBPO, elle active la ligne commune de sélection SBPO ;
- Sinon, si elle reçoit un 1 sur la ligne commune de candidature CBPZ, elle active la ligne commune de sélection SBPZ.

Pour la sélection par priorité "inférieure", pour chacun des P bits, l'unité PSU émet un 1 sur une des 2 lignes de bus de sélection comme suit (voir la **figure** 9) :
- Si l'unité PSU reçoit un 1 sur la ligne commune de candidature CBPZ, elle active la ligne commune de sélection SBPZ ;
- Sinon, si elle reçoit un 1 sur la ligne commune de candidature CBPO, elle active la ligne commune de sélection SBPO.

Dans les deux types d'unité PSU, l'inverseur O et la porte G autorisent la condition alternative "sinon" lorsque la condition préférée n'est pas remplie.

En outre, des amplificateurs (non représentés sur les **figures** 8 et 9) peuvent être prévus si besoin est sur les lignes de bus pour commander les conditions électriques de sortie sur ces lignes de bus.

De plus, une propriété intéressante de l'unité est que ses lignes de bus de sélection fournissent également une sortie explicite (non représentée sur les **figures** 2, 8 et 9) de la valeur numérique de niveau de priorité (supérieur ou inférieur) sélectionnée par le dispositif PSD, en plus des identités des éléments sélectionnés marquées sur les sorties ES de la matrice PSA. Ainsi, suivant l'application, le dispositif PSD peut fournir soit le niveau de priorité sélectionné, soit les identités des éléments sélectionnés, soit les deux.

### 6.4 - principe de tri par classe d'éléments avec cellules PSC du dispositif PSD

### 6.4.1 Principe

La présente proposition se fonde sur l'algorithme de tri suivant :
- L'algorithme de tri considéré consiste à sélectionner (trier) tous les éléments d'une même classe d'éléments (parmi C éléments candidats faisant partie de M éléments possibles) auxquels est associée une valeur numérique donnée, appelée clé de tri recherchée (SSK = "Searched Sorting Key"), afin d'identifier tous les éléments candidats appartenant à cette classe SSK ;
- N clés de tri distinctes sont codées avec P bits, n'importe quel type de codage étant utilisé (y compris un codage binaire naturel de 1 à n clés de tri codées sur P = log2N bits) ;
- Comme pour expliquer précédemment le principe utilisé pour la sélection par priorité, pour modéliser le processus de tri par classes d'éléments, on peut considérer une structure à deux dimensions de M x P bits en disposant les clés de tri des M éléments dans un tableau composé de M rangées et P colonnes, tel qu'il est représenté sur la **figure** 1 déjà commenté.
   En fait, pour les (M - C) éléments 11, 12 qui ne sont pas candidats à la sélection, cela n'a pas d'importance ici de supposer qu'ils ont également une clé de tri ou qu'ils n'en ont pas (d'où le code XX ... X dans leur rangée).
- Puis, pour les clés de tri définies ci-dessus associées aux M éléments, l'algorithme de tri peut simplement être effectué verticalement par une sélection bit par bit des rangées (éléments) ayant des bits qui correspondent à la clé de tri SSK donnée. Clairement, une telle opération peut être effectuée de nombreuses manières, en parallèle et/ou en série sur les P bits ; toutefois, de façon à étendre les possibilités des cellules PSC d'une matrice PSA de dispositif PSD, on propose d'effectuer cette opération de la même manière, à savoir en commençant par le bit de poids fort (MSB), jusqu'au bit de poids faible (LSB), c'est-à-dire le bit p.

En conséquence, la proposition d'un dispositif PSD amélioré, appelé PSD/ECS, avec fonction de tri par classe d'éléments (ECS = "Element Class Sorting") se présente naturellement comme suit :
- L'architecture d'un dispositif PSD/ECS est illustrée sur la **figure** 19, c'est-à-dire comportant :
   - Un dispositif PSD tel que défini précédemment, dans lequel on utilise la même matrice PSA et les mêmes cellules PSC (PSC-I, PSC-E1 ou PSC-E2) (la partie PSU n'étant pas utilisée en tant que telle dans le dispositif PSD/ECS) ;
   - Et unité de tri par classe d'éléments ECSU spécifique (= "Element Class Sorting Unit ") rajoutée au PSD proprement dit, cette unité ESCU:
      - étant raccordée aux P ensembles de lignes communes (systèmes de bus) BS de la matrice PSA,
      - et ayant P entrées externes pour recevoir la clé de tri recherchée donnée (SSK), c'est-à-dire SSK1, SSKj, ...SSKp.

La définition d'une unité ECSU peut être faite en deux versions, c'est-à-dire :
- une première version ECSU1 uniquement capable de commander le processus de tri, représentée sur la **figure** 20 ;
- une deuxième version ECSU2 également capable de détecter la présence (ou absence) d'éléments triés qui sont candidats et qui appartiennent à la classe SSK, en sortant un signal de présence d'éléments triés (SEP = "Selected Element Presence"), version représentée sur la **figure** 21.

### 6.4.2 remarques :

Si l'on considère un pur dispositif de tri par classe d'éléments fondé sur ce principe, c'est-à-dire en éliminant toute fonction nécessaire à des fins de sélection par rang, la partie PSU serait supprimée, ainsi que les deux lignes communes de candidature CBPZj et CBPOj de chaque système de lignes communes BSj dans la première version avec ECSU 1.

### 6.5 - Autres applications mises en oeuvre dans l'unité de sélection (PSU)

Six autres applications sont possibles, grâce à des moyens additionnels (de filtrage) dans l'unité PSU, permettant alors d'effectuer en outre :
1) La recherche d'éléments ayant une valeur numérique supérieure ou égale à une valeur numérique donnée dite de seuil plancher (LTV). L'unité de sélection (PSU) applique alors, pour chacun desdits P éléments binaires, un filtrage sur l'élément binaire candidat de polarité 0 (CBPZ) qui n'est pas autorisé lorsque le bit correspondant (LTVB) de ladite valeur numérique de seuil plancher est de polarité 1. En effet, afin d'appliquer un filtrage avec un seuil plancher (LTV) dans l'unité de sélection (PSU), pour chacun des bits j successifs, les éléments binaires candidats de polarité 0 et 1 (CBPZ ET CBPO) peuvent être tous deux autorisés lorsque le bit correspondant du seuil plancher (LTVB) est de polarité 0 ; par contre, seul l'élément binaire candidat de polarité 1 (CBPO) peut être autorisé lorsque le bit correspondant du seuil plancher (LTVB) est de polarité 1. Pour cela, l'unité de sélection (PSU) effectue les opérations suivantes :
   - activation de la ligne commune de sélection correspondant à un élément binaire sélectionné de polarité 1 (SBPO), si un signal actif est reçu sur la ligne commune de candidature correspondant à un élément binaire candidat de polarité 1 (CBPO);
   - activation de la ligne commune de sélection correspondant à un élément binaire sélectionné de polarité 0 (SBPZ), si un signal actif est reçu sur la ligne commune de candidature correspondant à un élément binaire candidat de polarité 0 (CBPZ), et si simultanément le bit correspondant (LTVB) de ladite valeur numérique de seuil plancher est de polarité 0.
2) La recherche d'éléments ayant une valeur numérique inférieure ou égale à une valeur numérique donnée dite de seuil plafond (HTV). L'unité de sélection (PSU) applique alors, pour chacun desdits P éléments binaires, un filtrage sur l'élément binaire candidat de polarité 1 (CBPO) qui n'est pas autorisé lorsque le bit correspondant (HTVB) de ladite valeur numérique de seuil plafond est de polarité 0. En effet, afin d'appliquer un filtrage avec un seuil plafond (HTV) dans l'unité de sélection (PSU), pour chacun des bits j successifs, les éléments binaires candidats de polarité 0 et 1 (CBPZ ET CBPO) peuvent être tous deux autorisés lorsque le bit correspondant du seuil plafond (HTVB) est de polarité 1 ; par contre, seul l'élément binaire candidat de polarité 0 (CBPZ) peut être autorisé lorsque le bit correspondant du seuil plafond (HTVB) est de polarité 0. Pour cela, l'unité de sélection (PSU) effectue les opérations suivantes:
   - activation de la ligne commune de sélection correspondant à un élément binaire sélectionné de polarité 1 (SBPO), si un signal actif est reçu sur la ligne commune de candidature correspondant à un élément binaire candidat de polarité 1 (CBPO), et si simultanément le bit correspondant (HTVB) de ladite valeur numérique de seuil plafond est de polarité 1;
   - activation de la ligne commune de sélection correspondant à un élément binaire sélectionné de polarité 0 (SBPZ), si un signal actif est reçu sur la ligne commune de candidature correspondant à un élément binaire candidat de polarité 0 (CBPZ).
3) La recherche d'éléments ayant la plus grande valeur numérique qui soit supérieure ou égale à une valeur numérique donnée dite de seuil plancher (LTV). L'unité de sélection (PSU), pour chacun desdits P éléments binaires, applique d'abord un filtrage identique au cas 1 ci-dessus [à savoir sur l'élément binaire candidat de polarité 0 (CBPZ) qui n'est pas autorisé lorsque le bit correspondant (LTVB) de ladite valeur numérique de seuil plancher est de polarité 1], et sélectionne ensuite la plus haute polarité binaire encore candidate pour sélection, en effectuant les opérations suivantes :
   - activation de la ligne commune de sélection correspondant à un élément binaire sélectionné de polarité 1 (SBPO), si un signal actif est reçu sur la ligne commune de candidature correspondant à un élément binaire candidat de polarité 1 (CBPO);
   - sinon, activation de la ligne commune de sélection correspondant à un élément binaire sélectionné de polarité 0 (SBPZ), si un signal actif est reçu sur la ligne commune de candidature correspondant à un élément binaire candidat de polarité 0 (CBPZ), et si simultanément le bit correspondant (LTVB) de ladite valeur numérique de seuil plancher est de polarité 0.
4) La recherche d'éléments ayant la plus grande valeur numérique qui soit inférieure ou égale à une valeur numérique donnée dite de seuil plafond (HTV). L'unité de sélection (PSU), pour chacun desdits P éléments binaires, applique d'abord un filtrage identique au cas 2 ci-dessus [à savoir sur l'élément binaire candidat de polarité 1 (CBPO) qui n'est pas autorisé lorsque le bit correspondant (HTVB) de ladite valeur numérique de seuil plafond est de polarité 0], et sélectionne ensuite la plus haute polarité binaire encore candidate pour sélection, en effectuant les opérations suivantes:
   - activation de la ligne commune de sélection correspondant à un élément binaire sélectionné de polarité 1 (SBPO), si un signal actif est reçu sur la ligne commune de candidature correspondant à un élément binaire candidat de polarité 1 (CBPO), et si simultanément le bit correspondant (HTVB) de ladite valeur numérique de seuil plafond est de polarité 1;
   - sinon, activation de la ligne commune de sélection correspondant à un élément binaire sélectionné de polarité 0 (SBPZ), si un signal actif est reçu sur la ligne commune de candidature correspondant à un élément binaire candidat de polarité 0 (CBPZ).
5) La recherche d'éléments ayant la plus petite valeur numérique qui soit supérieure ou égale à une valeur numérique donnée dite de seuil plancher (LTV). L'unité de sélection (PSU), pour chacun desdits P éléments binaires, applique d'abord un filtrage identique au cas 1 ci-dessus [à savoir sur l'élément binaire candidat de polarité 0 (CBPZ) qui n'est pas autorisé lorsque le bit correspondant (LTVB) de ladite valeur numérique de seuil plancher est de polarité 1], et sélectionne ensuite la plus basse polarité binaire encore candidate pour sélection, en effectuant les opérations suivantes :
   - activation de la ligne commune de sélection correspondant à un élément binaire sélectionné de polarité 0 (SBPZ), si un signal actif est reçu sur la ligne commune de candidature correspondant à un élément binaire candidat de polarité 0 (CBPZ), et si simultanément le bit correspondant (LTVB) de ladite valeur numérique de seuil plancher est de polarité 0;
   - sinon, activation de la ligne commune de sélection correspondant à un élément binaire sélectionné de polarité 1 (SBPO), si un signal actif est reçu sur la ligne commune de candidature correspondant à un élément binaire candidat de polarité 1 (CBPO).
6) La recherche d'éléments ayant la plus petite valeur numérique qui soit inférieure ou égale à une valeur numérique donnée dite de seuil plafond (HTV). L'unité de sélection (PSU), pour chacun desdits P éléments binaires, applique d'abord un filtrage identique au cas 2 ci-dessus [à savoir sur l'élément binaire candidat de polarité 1 (CBPO) qui n'est pas autorisé lorsque le bit correspondant (HTVB) de ladite valeur numérique de seuil plafond est de polarité 0], et sélectionne ensuite la plus basse polarité binaire encore candidate pour sélection, en effectuant les opérations suivantes:
   - activation de la ligne commune de sélection correspondant à un élément binaire sélectionné de polarité 0 (SBPZ), si un signal actif est reçu sur la ligne commune de candidature correspondant à un élément binaire candidat de polarité 0 (CBPZ);
   - sinon, activation de la ligne commune de sélection correspondant à un élément binaire sélectionné de polarité 1 (SBPO), si un signal actif est reçu sur la ligne commune de candidature correspondant à un élément binaire candidat de polarité 1 (CBPO), et si simultanément le bit correspondant (HTVB) de ladite valeur numérique de seuil plafond est de polarité 1.

La réalisation des moyens de filtrage additionnels remplissant les fonctions décrites ci-dessus sont à la portée de l'Homme de l'Art.

## Revendications

1. Dispositif de sélection par valeur numérique de sélection d'au moins un élément parmi un sous-ensemble de C éléments candidats à la sélection, faisant partie d'un ensemble de M éléments possibles, une valeur numérique de sélection étant affectée à chacun desdits M éléments possibles, parmi N valeurs numériques de sélection possibles,
ledit dispositif mettant en oeuvre une matrice de sélection par priorité (PSA) à deux dimensions comprenant M x P cellules de sélection organisées en M lignes et P colonnes, P étant le nombre d'éléments binaires, ou bits, nécessaires au codage de N valeurs distinctes, la cellule (i, j) correspondant à l'intersection d'une ligne de l'élément i et d'une colonne du bit j,
chacun desdits M éléments possibles correspondant à une desdites M lignes, à laquelle est associée la valeur numérique de sélection affectée à cet élément,
et chacune desdites lignes recevant sur son entrée d'élément (EEi) un signal d'élément candidat (ECi), indiquant si l'élément correspondant est ou non un élément candidat à la sélection, et délivrant sur sa sortie d'élément (SEi) un signal d'élément sélectionné (ESi) indiquant si l'élément correspondant est ou non un élément sélectionné,
la sélection étant effectuée par une analyse colonne par colonne des éléments binaires codant lesdites valeurs numériques de sélection dans ladite matrice de sélection par priorité,
la sélection effectuée pour une colonne de rang j conditionnant, pour chaque cellule (i, j) des M éléments, la transmission ou non d'un signal d'élément binaire retenu (BRi,j) vers la cellule de rang j+1 du même élément, ce signal correspondant alors audit signal d'élément sélectionné (ESi), indiquant si l'élément correspondant est ou non un élément sélectionné, lorsque la cellule de rang j correspond au dernier bit de poids le plus faible ;
**caractérisé en ce qu'**il comprend une unité de sélection (PSU) raccordée à ladite matrice (PSA) par P ensembles de lignes communes correspondant aux dites P colonnes de ladite matrice, cette unité commandant le processus de sélection bit à bit dans chaque cellule (PSCi, j) de ladite matrice (PSA), chaque cellule étant raccordée à l'ensemble de lignes communes de la colonne j correspondante,
et **en ce que** ladite unité de sélection (PSU) fournit, sur au moins une ligne commune par colonne pour chacun des P bits, la polarité binaire sélectionnée résultant de la sélection qu'elle commande par colonne j.

2. Dispositif de sélection d'éléments par valeur numérique de sélection selon la revendication 1, **caractérisé en ce que** P= log2N, lesdites valeurs numériques de sélection étant codées selon le codage binaire naturel.

3. Dispositif de sélection d'éléments par valeur numérique de sélection selon la revendication 1, **caractérisé en ce que** chacun desdits P ensembles de lignes communes comprend :
- deux lignes communes de candidature allant de ladite matrice (PSA) à ladite unité de sélection (PSU), une première ligne commune de candidature (CBPOj) indiquant la présence ou non d'une polarité binaire 1 candidate pour sélection parmi toutes les cellules i, j de la colonne correspondante j, et une seconde ligne commune de candidature (CBPZj) indiquant la présence ou non d'une polarité binaire 0 candidate pour sélection parmi toutes les cellules (i, j) de la colonne correspondante j; et
- deux lignes communes de sélection allant de l'unité de sélection (PSU) à ladite matrice (PSA), une première ligne commune de sélection (SBPOj) indiquant si la polarité binaire 1 est sélectionnée ou non parmi toutes les cellules (i, j) de la colonne correspondante j, et une seconde ligne commune de sélection (SBPZj) indiquant si la polarité binaire 0 est sélectionnée ou non parmi toutes les cellules (i, j) de la colonne correspondante j.

4. Dispositif de sélection d'éléments par valeur numérique de sélection selon la revendication 1, **caractérisé en ce que**, dans ladite matrice (PSA), chaque cellule de sélection par priorité (PSCi, j), correspondant à un élément particulier (Ei) et à un élément binaire particulier (Bj), est raccordée :
- selon la dimension M, à la cellule précédente (PSCi, j-1) par une ligne entrante d'élément binaire candidat (EBCi, j) pour recevoir un signal d'entrée d'élément binaire retenu (BRi, j-1/j) et à la cellule suivante (PSCi, j+1) par une ligne sortante d'élément binaire retenu (SBRi, j) pour transmettre un signal de sortie d'élément binaire retenu (BRi, j/j+1), chaque ligne entrante d'élément binaire candidat (EBCi, j) étant raccordée à la ligne sortante d'élément binaire retenu (SBSi, j-1) de la cellule précédente et chaque ligne sortante d'élément binaire retenu (SBSi, j) étant raccordée à la ligne entrante d'élément binaire candidat (EBCi, j+1) de la cellule suivante, et où la ligne entrante d'élément binaire candidat (EBCi, 1) de la première cellule (PSCi, 1) est raccordée à l'entrée de matrice (EEi) de l'élément (Ei), qui reçoit ledit signal d'élément candidat (ECi), et la ligne sortante d'élément binaire retenu (SBSi, p) de la dernière cellule (PSCi, p) est raccordée à la sortie de matrice (SEi) de l'élément (Ei), qui délivre ledit signal d'élément sélectionné (ESi) ;
- et selon la dimension P, à l'ensemble de lignes communes (BSj) relatif à l'élément binaire (Bj), qui comprend deux lignes communes de candidature (CBPZj et CPBOj) interconnectant toutes les cellules (PSCi, j) relatives au même élément binaire (Bj) ainsi que l'unité de sélection par priorité (PSU), et deux lignes communes de sélection provenant de l'unité de sélection par priorité, une première ligne commune de sélection (SBPOj) indiquant si la polarité binaire 1 est sélectionnée ou non parmi toutes les cellules (i, j) de la colonne correspondante j, et la seconde ligne commune de sélection (SBPZj) indiquant si la polarité binaire 0 est sélectionnée ou non parmi toutes les cellules (i, j) de la colonne correspondante j.

5. Dispositif de sélection d'éléments par valeur numérique de sélection selon la revendication 1, **caractérisé en ce que** la valeur numérique de sélection affectée à au moins certains desdits éléments est fixe, et intégrée de façon implicite dans les cellules de chacun des éléments à valeur numérique fixe, chacune des cellules correspondantes étant alors différenciée en fonction de la polarité de l'élément binaire implicite dans ladite valeur numérique fixe.

6. Dispositif de sélection d'éléments par valeur numérique de sélection selon les revendications 4 et 5, **caractérisé en ce que** chacune desdites cellules des éléments à valeur numérique fixe comprend :
- une diode de découplage (D) formant un "OU CABLE", dirigeant ledit signal d'entrée d'élément binaire retenu (BRi, j-1/j) vers celle des deux lignes communes de candidature (CBPZj ou CBPOj) dont la polarité binaire correspond à celle de l'élément binaire implicite de la valeur numérique fixe de sélection affecté à cette cellule, indiquant si ainsi, sur les lignes communes de candidature, la polarité binaire de ce bit implicite, en activant la ligne commune de candidature appropriée (CBPZj ou CBPOj) lorsque ledit signal d'entrée d'élément binaire retenu (BRi, j-1/j) est actif ;
- une porte "ET" (G) délivrant ledit signal de sortie d'élément binaire retenu (BRi, j/j+1), et alimentée par ledit signal d'entrée d'élément binaire retenu (BRi, j-1/j) et par celle des deux lignes communes de sélection (SBPZj ou SBPOj) dont la polarité binaire correspond à celle de l'élément binaire implicite affecté à cette cellule, indiquant si la polarité binaire correspondant à celle de cet élément binaire implicite est sélectionnée, de façon que ledit signal de sortie d'élément binaire retenu (BRi, j/j+1) soit actif lorsque ledit signal d'entrée d'élément binaire retenu (BRi, j-1/j) est actif et que simultanément un signal actif est reçu sur la ligne commune de sélection dont la polarité binaire correspond à celle de l'élément binaire implicite affecté à cette cellule.

7. Dispositif de sélection d'éléments par valeur numérique de sélection selon la revendication 1, **caractérisé en ce que** la valeur numérique de sélection affectée à au moins certains desdits éléments est explicite et mémorisée de façon dynamique ou semi-permanente.

8. Dispositif de sélection d'éléments par valeur numérique de sélection selon la revendication 7, **caractérisé en ce que** ladite valeur numérique de sélection explicite est mémorisée à l'intérieur de ladite matrice (PSA).

9. Dispositif de sélection d'éléments par valeur numérique de sélection selon la revendication 7, **caractérisé en ce que** ladite valeur numérique de sélection explicite est mémorisée dans une mémoire externe, associée bit par bit à ladite matrice (PSA), chaque cellule de cette matrice recevant de ladite mémoire externe un élément binaire de la valeur numérique mémorisée.

10. Dispositif de sélection d'éléments par valeur numérique de sélection selon l'une quelconque des revendications 8 ou 9, **caractérisé en ce que** chacune desdites cellules (PSCi, j) comprend :
- deux portes "ET" à deux entrées (G1Z et G1O), dont l'une des entrées est reliée audit signal d'entrée d'élément binaire retenu (BRi, j-1/j), la première porte "ET" (G1Z) correspondant à la polarité 0 ayant son autre entrée reliée à la polarité 0 de l'élément binaire explicite mémorisé, et la seconde porte "ET" (G1O) correspondant à la polarité 1 ayant son autre entrée reliée à la polarité 1 de l'élément binaire explicite mémorisé ;
- deux diodes de découplage (DZ et DO) formant un "OU CABLE", une première diode (DZ) dirigeant la sortie de ladite première porte "ET" (G1Z) vers la ligne commune de candidature de polarité binaire 0 (CBPZj), et une seconde diode (DO) dirigeant la sortie de ladite seconde porte "ET" (G1O) vers la ligne commune de candidature de polarité binaire 1 (CBPOj), indiquant ainsi, sur ces lignes communes de candidature, la polarité binaire correspondant à l'élément binaire explicite mémorisé, en activant la ligne commune de candidature appropriée (CBPZj ou CBPOj) lorsque ledit signal d'entrée d'élément binaire retenu est actif ;
- et deux autres portes "ET" à deux entrées (G2Z et G2O) dont les sorties alimentent une porte "OU" (G3) délivrant ledit signal de sortie d'élément binaire retenu (BRi,j/j+1), la troisième porte "ET" (G2Z) correspondant à la polarité 0 ayant une entrée reliée à la sortie de ladite première porte "ET" (G1Z) et une autre entrée reliée à la ligne commune de sélection de polarité 0 (SBPZj), et la quatrième porte "ET" (G2O) correspondant à la polarité 1 ayant une entrée reliée à la sortie de ladite seconde porte "ET" (G1O) et une autre entrée reliée à l'autre ligne commune de sélection de polarité 1 (SBPOj), indiquant si la polarité binaire correspondant à celle de l'élément binaire explicite mémorisé est sélectionnée, de façon que ledit signal de sortie d'élément binaire retenu (BRi, j/j+1) soit actif lorsque ledit signal d'entrée d'élément binaire retenu (BRi, j-1/j) est actif et que simultanément un signal actif est reçu sur la ligne commune de sélection dont la polarité binaire correspond à celle de l'élément binaire explicite mémorisé correspondant à cette cellule.

11. Dispositif de sélection d'éléments par valeur numérique de sélection selon la revendication 3, **caractérisé en ce qu'**il met en oeuvre une recherche de la plus grande valeur numérique de sélection, ladite unité de sélection (PSU) effectuant les opérations suivantes, pour chacun desdits P éléments binaires :
- si un signal actif est reçu sur la ligne commune de candidature correspondant à un élément binaire candidat de polarité 1 (CBPO), activation de la ligne commune de sélection correspondant à un élément binaire sélectionné de polarité 1 (SBPO) ;
- sinon, si un signal actif est reçu sur la ligne commune de candidature correspondant à un élément binaire candidat de polarité 0 (CBPZ), activation de la ligne commune de sélection correspondant à un élément binaire sélectionné de polarité 0 (SBPZ).

12. Dispositif de sélection d'éléments par valeur numérique de sélection selon la revendication 3, **caractérisé en ce qu'**il met en oeuvre une recherche de plus petite valeur numérique de sélection, ladite unité de sélection (PSU) effectuant les opérations suivantes, pour chacun desdits P éléments binaires :
- si un signal actif est reçu sur la ligne commune de candidature correspondant à un élément binaire candidat de polarité 0 (CBPZ), activation de la ligne commune de sélection correspondant à un élément binaire sélectionné de polarité 0 (SBPZ) ;
- sinon, si un signal actif est reçu sur la ligne commune de candidature correspondant à un élément binaire candidat de polarité 1 (CBPO), activation de la ligne commune de sélection correspondant à un élément binaire sélectionné de polarité 1 (SBPO).

13. Dispositif de sélection d'éléments par valeur numérique de sélection selon la revendication 1, pour effectuer dans le dispositif une opération de recherche des éléments ayant une valeur numérique donnée (SSK) parmi les C éléments candidats pour sélection faisant partie des M éléments de la matrice (PSA),
**caractérisé en ce que** ledit dispositif comprend en outre une unité d'identification d'éléments par valeur numérique de sélection donnée (ECSU) connectée à ladite matrice par P couples de lignes communes de sélection allant de ladite unité d'identification à ladite matrice (PSA), chaque couple de lignes comprenant une première ligne commune de sélection (SBPOj) indiquant si la polarité binaire 1 est sélectionnée ou non pour la colonne correspondante j, et une seconde ligne commune de sélection (SBPZj) indiquant si la polarité binaire 0 est sélectionnée ou non pour la colonne correspondante j,
et **en ce que** ladite unité d'identification d'éléments :
- reçoit le code de la valeur numérique de sélection recherchée (SSK),
- et positionne, pour chaque colonne j, lesdites lignes communes de sélection en fonction de la polarité des bits de la valeur numérique donnée (SSK) recherchée parmi les C éléments candidats pour sélection.

14. Dispositif de sélection d'éléments par valeur numérique de sélection selon la revendication 13, **caractérisé en ce que** ladite unité d'identification d'éléments par valeur numérique de sélection donnée (ECSU) délivre également un signal de présence d'au moins un élément identifié, et **en ce que** ladite unité :
- est connectée à la matrice (PSA) par P couples de lignes communes de candidature allant de la matrice à ladite unité d'identification (ECSU), une première ligne commune de candidature (CBPOj) indiquant la présence ou non d'une polarité binaire 1 candidate pour sélection parmi toutes les cellules i, j de la colonne correspondante j, et la seconde ligne commune de candidature (CBPZj) indiquant la présence ou non d'une polarité binaire 0 candidate pour sélection parmi toutes les cellules i, j de la colonne correspondantej ; et
- détecte la présence ou l'absence d'éléments recherchés en effectuant une comparaison bit à bit entre les codes des éléments candidats à la sélection qu'elle reçoit sur lesdites lignes communes de candidature et le code de la valeur numérique de sélection donnée (SSK) recherchée parmi les C éléments candidats pour sélection.

15. Dispositif de sélection d'éléments par valeur numérique de sélection selon la revendication 3, **caractérisé en ce qu'**il met en oeuvre une recherche des valeurs numériques de sélection qui sont supérieures ou égales à une valeur numérique de seuil plancher (LTV) donnée, ladite unité de sélection (PSU) appliquant, pour chacun desdits P éléments binaires, un filtrage sur l'élément binaire candidat de polarité 0 (CBPZ) qui n'est pas autorisé lorsque le bit correspondant (LTVB) de ladite valeur numérique de seuil plancher est de polarité 1, en effectuant les opérations suivantes :
- activation de la ligne commune de sélection correspondant à un élément binaire sélectionné de polarité 1 (SBPO), si un signal actif est reçu sur la ligne commune de candidature correspondant à un élément binaire candidat de polarité 1 (CBPO);
- activation de la ligne commune de sélection correspondant à un élément binaire sélectionné de polarité 0 (SBPZ), si un signal actif est reçu sur la ligne commune de candidature correspondant à un élément binaire candidat de polarité 0 (CBPZ), et si simultanément le bit correspondant (LTVB) de ladite valeur numérique de seuil plancher est de polarité 0.

16. Dispositif de sélection d'éléments par valeur numérique de sélection selon la revendication 3, **caractérisé en ce qu'**il met en oeuvre une recherche des valeurs numériques de sélection qui sont inférieures ou égales à une valeur numérique de seuil plafond (HTV) donnée, ladite unité de sélection (PSU) appliquant, pour chacun desdits P éléments binaires, un filtrage sur l'élément binaire candidat de polarité 1 (CBPO) qui n'est pas autorisé lorsque le bit correspondant (HTVB) de ladite valeur numérique de seuil plafond est de polarité 0, en effectuant les opérations suivantes :
- activation de la ligne commune de sélection correspondant à un élément binaire sélectionné de polarité 1 (SBPO), si un signal actif est reçu sur la ligne commune de candidature correspondant à un élément binaire candidat de polarité 1 (CBPO), et si simultanément le bit correspondant (HTVB) de ladite valeur numérique de seuil plafond est de polarité 1;
- activation de la ligne commune de sélection correspondant à un élément binaire sélectionné de polarité 0 (SBPZ), si un signal actif est reçu sur la ligne commune de candidature correspondant à un élément binaire candidat de polarité 0 (CBPZ).

17. Dispositif de sélection d'éléments par valeur numérique de sélection selon les revendications 1 et 15, **caractérisé en ce qu'**il met en oeuvre une recherche de la plus grande valeur numérique de sélection parmi celles qui sont supérieures ou égales à une valeur numérique de seuil plancher (LTV) donnée, ladite unité de sélection (PSU), pour chacun desdits P éléments binaires, appliquant d'abord un filtrage sur l'élément binaire candidat de polarité 0 (CBPZ) qui n'est pas autorisé lorsque le bit correspondant (LTVB) de ladite valeur numérique de seuil plancher est de polarité 1, et sélectionnant ensuite la plus haute polarité binaire encore candidate pour sélection, en effectuant les opérations suivantes :
- activation de la ligne commune de sélection correspondant à un élément binaire sélectionné de polarité 1 (SBPO), si un signal actif est reçu sur la ligne commune de candidature correspondant à un élément binaire candidat de polarité 1 (CBPO);
- sinon, activation de la ligne commune de sélection correspondant à un élément binaire sélectionné de polarité 0 (SBPZ), si un signal actif est reçu sur la ligne commune de candidature correspondant à un élément binaire candidat de polarité 0 (CBPZ), et si simultanément le bit correspondant (LTVB) de ladite valeur numérique de seuil plancher est de polarité 0.

18. Dispositif de sélection d'éléments par valeur numérique de sélection selon les revendications 11 et 16, **caractérisé en ce qu'**il met en oeuvre une recherche de la plus grande valeur numérique de sélection parmi celles qui sont inférieures ou égales à une valeur numérique de seuil plafond (HTV) donnée, ladite unité de sélection (PSU), pour chacun desdits P éléments binaires, appliquant d'abord un filtrage sur l'élément binaire candidat de polarité 1 (CBPO) qui n'est pas autorisé lorsque le bit correspondant (HTVB) de ladite valeur numérique de seuil plafond est de polarité 0, et sélectionnant ensuite la plus haute polarité binaire encore candidate pour sélection, en effectuant les opérations suivantes :
- activation de la ligne commune de sélection correspondant à un élément binaire sélectionné de polarité 1 (SBPO), si un signal actif est reçu sur la ligne commune de candidature correspondant à un élément binaire candidat de polarité 1 (CBPO), et si simultanément le bit correspondant (HTVB) de ladite valeur numérique de seuil plafond est de polarité 1;
- sinon, activation de la ligne commune de sélection correspondant à un élément binaire sélectionné de polarité 0 (SBPZ), si un signal actif est reçu sur la ligne commune de candidature correspondant à un élément binaire candidat de polarité 0 (CBPZ).

19. Dispositif de sélection d'éléments par valeur numérique de sélection selon les revendications 12 et 15, **caractérisé en ce qu'**il met en oeuvre une recherche de la plus petite valeur numérique de sélection parmi celles qui sont supérieures ou égales à une valeur numérique de seuil plancher (LTV) donnée, ladite unité de sélection (PSU), pour chacun desdits P éléments binaires, appliquant d'abord un filtrage sur l'élément binaire candidat de polarité 0 (CBPZ) qui n'est pas autorisé lorsque le bit correspondant (LTVB) de ladite valeur numérique de seuil plancher est de polarité 1, et sélectionnant ensuite la plus basse polarité binaire encore candidate pour sélection, en effectuant les opérations suivantes :
- activation de la ligne commune de sélection correspondant à un élément binaire sélectionné de polarité 0 (SBPZ), si un signal actif est reçu sur la ligne commune de candidature correspondant à un élément binaire candidat de polarité 0 (CBPZ), et si simultanément le bit correspondant (LTVB) de ladite valeur numérique de seuil plancher est de polarité 0;
- sinon, activation de la ligne commune de sélection correspondant à un élément binaire sélectionné de polarité 1 (SBPO), si un signal actif est reçu sur la ligne commune de candidature correspondant à un élément binaire candidat de polarité 1 (CBPO).

20. Dispositif de sélection d'éléments par valeur numérique de sélection selon les revendications 12 et 16, **caractérisé en ce qu'**il met en oeuvre une recherche de la plus petite valeur numérique de sélection parmi celles qui sont inférieures ou égales à une valeur numérique de seuil plafond (HTV) donnée, ladite unité de sélection (PSU), pour chacun desdits P éléments binaires, appliquant d'abord un filtrage sur l'élément binaire candidat de polarité 1 (CBPO) qui n'est pas autorisé lorsque le bit correspondant (HTVB) de ladite valeur numérique de seuil plafond est de polarité 0, et sélectionnant ensuite la plus basse polarité binaire encore candidate pour sélection, en effectuant les opérations suivantes :
- activation de la ligne commune de sélection correspondant à un élément binaire sélectionné de polarité 0 (SBPZ), si un signal actif est reçu sur la ligne commune de candidature correspondant à un élément binaire candidat de polarité 0 (CBPZ);
- sinon, activation de la ligne commune de sélection correspondant à un élément binaire sélectionné de polarité 1 (SBPO), si un signal actif est reçu sur la ligne commune de candidature correspondant à un élément binaire candidat de polarité 1 (CBPO), et si simultanément le bit correspondant (HTVB) de ladite valeur numérique de seuil plafond est de polarité 1.

## Claims

1. Device for selection through numerical selection value of at least one element from among a sub-group of C candidate elements for selection, forming part of a group of M possible elements, a numerical selection value being assigned to each of said M possible elements, among N possible numerical selection values,
said device implementing a two-dimensional priority selection array (PSA) comprising M x P selection cells arranged in M lines and P columns, P being the number of binary digits, or bits, required for the coding of N separate values, the cell (i, j) corresponding to the intersection of a line of the element i and a column of the bit j,
each of said M possible elements corresponding to one of said M lines, with which the numerical selection value assigned to this element is associated, and each of said lines receiving on its element input (EEi) a candidate element (ECi) signal, indicating whether or not the corresponding element is a candidate for selection, and delivering on its element output (SEi) a selected element (ESi) signal indicating whether or not the corresponding element is a selected element,
the selection being made by a column by column analysis of the bits coding said numerical selection values in said priority selection array,
the selection made for a column with rank j determining, for each cell (i, j) of the M elements, whether or not a retained bit (BRi,j) signal is sent to the cell of rank j+l of the same element, this signal then corresponding to said selected element (ESi) signal, indicating whether or not the corresponding element is a selected element, when the cell of rank j corresponds to the final least significant bit;
**characterized in that** it comprises a selection unit (PSU) connected to said array (PSA) by P common line systems corresponding to said P columns of said array, this unit controlling the selection process bit by bit in each cell (PSCi, j) of said array (PSA), each cell being connected to the common line system of the corresponding column j,
and **in that** said selection unit (PSU) provides, on at least one common line per column for each of the P bits, the selected binary polarity resulting from the selection it controls through column j.

2. Device for selection of elements through numerical selection value according to claim 1, **characterized in that** P= log2N, said numerical selection values being coded using natural binary coding.

3. Device for selection of elements through numerical selection value according to claim 1, **characterized in that** each of said P common line systems comprises:
- two candidature common lines going from said array (PSA) to said selection unit (PSU), a first candidature common line (CBPOj) indicating whether or not a binary polarity 1 candidate for selection is present among all the cells i, j of the corresponding column j, and a second candidature common line (CBPZj) indicating whether or not a binary polarity 0 candidate for selection is present among all the cells (i, j) of the corresponding column j; and
- two selection common lines going from the selection unit (PSU) to said array (PSA), a first selection common line (SBPOj) indicating whether or not the binary polarity 1 is selected among all the cells (i, j) of the corresponding column j, and a second selection common line (SBPZj) indicating whether or not the binary polarity 0 is selected among all the cells (i, j) of the corresponding column j.

4. Device for selection of elements through numerical selection value according to claim 1, **characterized in that**, in said array (PSA), each priority selection cell (PSCi, j), corresponding to a specific element (Ei) and to a specific bit (Bj), is connected:
- in accordance with the dimension M, to the previous cell (PSCi, j-1) by a candidate bit input (EBCi, j) for receiving a retained bit input signal (BRi, j-1/j) and to the following cell (PSCi, j+l) by a retained bit output (SBRi, j) for sending the retained bit output signal (BRi, j/j+1), with each candidate bit input (EBCi, j) being connected to the selected bit output (SBSi, j-1) of the previous cell and each selected bit output (SBSi, j) being connected to the candidate bit input (EBCi, j+l) of the following cell, and where the candidate bit input (EBCi, 1) of the first cell (PSCi, 1) is connected to the array input (EEi) of the element (Ei), which receives said candidate element (ECi) signal, and the selected bit output (SBSi, p) of the last cell (PSCi, p) is connected to the array output (SEi) of the element (Ei), which delivers said selected element (ESi) signal;
- and in accordance with the dimension P, to all common lines (BSj) relating to the bit (Bj), which comprises two candidature common lines (CBPZj and CPBOj) interconnecting all the cells (PSCi, j) relating to the same bit (Bj) as well as the priority selection unit (PSU), and two selection common lines from the priority selection unit, a first selection common line (SBPOj) indicating whether or not the binary polarity 1 is selected from among all the cells (i, j) of the corresponding column j, and the second selection common line (SBPZj) indicating whether or not the binary polarity 0 is selected from among all the cells (i, j) of the corresponding column j.

5. Device for selection of elements through numerical selection value according to claim 1, **characterized in that** the numerical selection value assigned to at least some of said elements is fixed, and integrated implicitly in the cells of each of the elements with fixed numerical value, each of the corresponding cells then being distinguished based on the polarity of the implicit bit in said fixed numerical value.

6. Device for selection of elements through numerical selection value according to claims 4 and 5, **characterized in that** each of said cells of the fixed numerical value elements comprises:
- a decoupling diode (D) forming an "OR CABLE", directing said retained bit input signal (BRi, j-1/j) to that of the two candidature common lines (CBPZj or CBPOj) for which the binary polarity corresponds to that of the implicit bit of the fixed numerical selection value assigned to this cell, thus indicating the binary polarity of this implicit bit on the candidature common lines, by activating the appropriate candidature common line (CBPZj or CBPOj) when said retained bit input signal (BRi, j-l/j) is active;
- an "AND" gate (G) delivering said retained bit output signal (BRi, j/j+l), and powered by said retained bit input signal (BRi, j-l/j) and by that of the two selection common lines (SBPZj or SBPOj) for which the binary polarity corresponds to that of the implicit bit assigned to this cell, indicating whether the binary polarity corresponding to that of this implicit bit is selected, so that said retained bit output signal (BRi, j/j+l) is active when said retained bit input signal (BRi, j-l/j) is active and simultaneously an active signal is received on the selection common line for which the binary polarity corresponds to that of the implicit bit assigned to this cell.

7. Device for selection of elements through numerical selection value according to claim 1, **characterized in that** the numerical selection value assigned to at least some of said elements is explicit and stored in a dynamic or semi-permanent manner.

8. Device for selection of elements through numerical selection value according to claim 7, **characterized in that** said explicit numerical selection value is stored inside said array (PSA).

9. Device for selection of elements through numerical selection value according to claim 7, **characterized in that** said explicit numerical selection value is stored in an external memory, associated bit by bit with said array (PSA), each cell of this array receiving from said external memory a bit of the stored numerical value.

10. Device for selection of elements through numerical selection value according to either of claims 8 or 9, **characterized in that** each of said cells (PSCi, j) comprises:
- two "AND" gates with two inputs (G1Z and G1O), one of said inputs being connected to said retained bit input signal (BRi, j-l/j), the first "AND" gate (G1Z) corresponding to polarity 0 with its other input connected to the polarity 0 of the stored explicit bit, and the second "AND" gate (G1O) corresponding to the polarity 1 with its other input connected to the polarity 1 of the stored explicit bit;
- two decoupling diodes (DZ and DO) forming an "OR CABLE", a first diode (DZ) directing the output of said first "AND" gate (G1Z) to the candidature common line of binary polarity 0 (CBPZj), and a second diode (DO) directing the output of said second "AND" gate (GlO) to the candidature common line of binary polarity 1 (CBPOj), thus indicating, on these candidature common lines, the binary polarity corresponding to the stored explicit bit, by activating the appropriate candidature common line (CBPZj or CBPOj) when said retained bit input signal is active;
- and two other "AND" gates with two inputs (G2Z and G20), the outputs of which power an "OR" gate (G3) delivering said retained bit output signal (BRi, j/j+1), the third "AND" gate (G2Z) corresponding to the polarity 0 with one input connected to the output of said first "AND" gate (G1Z) and another input connected to the selection common line of polarity 0 (SBPZj), and the fourth "AND" gate (G2O) corresponding to polarity 1 with one input connected to the output of said second "AND" gate (G10) and another input connected to the other selection common line of polarity 1 (SBPOj), indicating whether the binary polarity corresponding to that of the stored explicit bit is selected, so that said retained bit output signal (BRi, j/j+l) is active when said retained bit input signal (BRi, j-1/j) is active and simultaneously an active signal is received on the selection common line for which the binary polarity corresponds to that of the stored explicit bit corresponding to this cell.

11. Device for selection of elements through numerical selection value according to claim 3, **characterized in that** it implements a search for the largest numerical selection value, said selection unit (PSU) carrying out the following operations for each of said P bits:
- if an active signal is received on the candidature common line corresponding to a candidate bit of polarity 1 (CBPO), activation of the selection common line corresponding to a selected bit of polarity 1 (SBPO);
- otherwise, if an active signal is received on the candidature common line corresponding to a candidate bit of polarity 0 (CBPZ), activation of the selection common line corresponding to a selected bit of polarity 0 (SBPZ).

12. Device for selection of elements through numerical selection value according to claim 3, **characterized in that** it implements a search for the smallest numerical selection value, said selection unit (PSU) carrying out the following operations for each of said P bits:
- if an active signal is received on the candidature common line corresponding to a candidate bit of polarity 0 (CBPZ), activation of the selection common line corresponding to a selected bit of polarity 0 (SBPZ);
- otherwise, if an active signal is received on the candidature common line corresponding to a candidate bit of polarity 1 (CBPO), activation of the selection common line corresponding to a selected bit of polarity 1 (SBPO).

13. Device for selection of elements by numerical selection value according to claim 1, to carry out in the device a search operation for the elements with a given numerical value (SSK) among the C candidate elements for selection forming part of the M elements of the array (PSA),
**characterized in that** said device also comprises a unit for the identification of elements through the given numerical selection value (ECSU) connected to said array by P pairs of selection common lines going from said identification unit to said array (PSA), each pair of lines comprising a first selection common line (SBPOj) indicating whether or not the binary polarity 1 is selected for the corresponding column j, and a second selection common line (SBPZj) indicating whether or not the binary polarity 0 is selected for the corresponding column j,
and **in that** said element identification unit:
- receives the code of the searched numerical selection value (SSK),
- and positions, for each column j, said selection common lines based on the polarity of the bits of the given numerical value (SSK) searched among the C candidate elements for selection.

14. Device for selection of elements through numerical selection value according to claim 13, **characterized in that** said unit for the identification of elements through the given numerical selection value (ECSU) also delivers a presence signal from at least one identified element,
and **in that** said unit:
- is connected to the array (PSA) by P pairs of candidature common lines going from the array to said identification unit (ECSU), a first candidature common line (CBPOj) indicating whether or not a binary polarity 1 candidate for selection is present among all the cells i, j of the corresponding column j, and the second candidature common line (CBPZj) indicating whether or not a binary polarity 0 candidate for selection is present among all the cells (i, j) of the corresponding column j; and
- detects the presence or the absence of searched elements by carrying out a bit by bit comparison between the codes of the candidate elements for selection that it receives on said candidature common lines and the code of the given numerical selection (SSK) searched among the C candidate elements for selection.

15. Device for selection of elements through numerical selection value according to claim 3, **characterized in that** it implements a search for the numerical selection values which are greater than or equal to a given low threshold numerical value (LTV), said selection unit (PSU) applying, for each of said P bits, a filter to the candidate bit of polarity 0 (CBPZ) which is not authorized when the corresponding bit (LTVB) of said low threshold numerical value has the polarity 1, by carrying out the following operations:
- activation of the selection common line corresponding to a selected bit of polarity 1 (SBPO), if an active signal is received on the candidature common line corresponding to a candidate bit of polarity 1 (CBPO);
- activation of the selection common line corresponding to a selected bit of polarity 0 (SBPZ), if an active signal is received on the candidature common line corresponding to a candidate bit of polarity 0 (CBPZ), and if simultaneously the corresponding bit (LTVB) of said low threshold numerical value has the polarity 0.

16. Device for selection of elements through numerical selection value according to claim 3, **characterized in that** it implements a search for the numerical selection values which are lower than or equal to a given high threshold numerical value (HTV), said selection unit (PSU) applying, for each of said P bits, a filter to the candidate bit of polarity 1 (CBPO) which is not authorized when the corresponding bit (HTVB) of said high threshold numerical value has the polarity 0, by carrying out the following operations:
- activation of the selection common line corresponding to a selected bit of polarity 1 (SBPO), if an active signal is received on the candidature common line corresponding to a candidate bit of polarity 1 (CBPO), and if simultaneously the corresponding bit (HTVB) of said high threshold numerical value has the polarity 1;
- activation of the selection common line corresponding to a selected bit of polarity 0 (SBPZ), if an active signal is received on the candidature common line corresponding to a candidate bit of polarity 0 (CBPZ).

17. Device for selection of elements through numerical selection value according to claims 11 and 15, **characterized in that** it implements a search for the largest numerical selection value among those which are greater than or equal to a given low threshold numerical value (LTV), said selection unit (PSU), for each of said P bits, applying first a filter to the candidate bit of polarity 0 (CBPZ) which is not authorized when the corresponding bit (LTVB) of said low threshold numerical value has the polarity 1, and then selecting the highest binary polarity still candidate for selection, by carrying out the following operations:
- activation of the selection common line corresponding to a selected bit of polarity 1 (SBPO), if an active signal is received on the candidature common line corresponding to a candidate bit of polarity 1 (CBPO);
- otherwise, activation of the selection common line corresponding to a selected bit of polarity 0 (SBPZ), if an active signal is received on the candidature common line corresponding to a candidate bit of polarity 0 (CBPZ), and if simultaneously the corresponding bit (LTVB) of said low threshold numerical value has the polarity 0.

18. Device for selection of elements through numerical selection value according to claims 11 and 16, **characterized in that** it implements a search for the largest numerical selection value among those which are lower than or equal to a given high threshold numerical value (HTV), said selection unit (PSU), for each of said P bits, applying first a filter to the candidate bit of polarity 1 (CBPO) which is not authorized when the corresponding bit (HTVB) of said high threshold numerical value has the polarity 0, and then selecting the highest binary polarity still candidate for selection, by carrying out the following operations:
- activation of the selection common line corresponding to a selected bit of polarity 1 (SBPO), if an active signal is received on the candidature common line corresponding to a candidate bit of polarity 1 (CBPO), and if simultaneously the corresponding bit (HTVB) of said high threshold numerical value has the polarity 1;
- otherwise, activation of the selection common line corresponding to a selected bit of polarity 0 (SBPZ), if an active signal is received on the candidature common line corresponding to a candidate bit of polarity 0 (CBPZ).

19. Device for selection of elements through numerical selection value according to claims 12 and 15, **characterized in that** it implements a search for the smallest numerical selection value among those which are greater than or equal to a given low threshold numerical value (LTV), said selection unit (PSU), for each of said P bits, applying first a filter to the candidate bit of polarity 0 (CBPZ) which is not authorized when the corresponding bit (LTVB) of said low threshold numerical value has the polarity 1, and then selecting the lowest binary polarity still candidate for selection, by carrying out the following operations:
- activation of the selection common line corresponding to a selected bit of polarity 0 (SBPZ), if an active signal is received on the candidature common line corresponding to a candidate bit of polarity 0 (CBPZ), and if simultaneously the corresponding bit (LTVB) of said low threshold numerical value has the polarity 0;
- otherwise, activation of the selection common line corresponding to a selected bit of polarity 1 (SBPO), if an active signal is received on the candidature common line corresponding to a candidate bit of polarity 1 (CBPO).

20. Device for selection of elements through numerical selection value according to claims 12 and 16, **characterized in that** it implements a search for the smallest numerical selection value among those which are lower than or equal to a given high threshold numerical value (HTV), said selection unit (PSU), for each of said P bits, applying first a filter to the candidate bit of polarity 1 (CBPO) which is not authorized when the corresponding bit (HTVB) of said high threshold numerical value has the polarity 0, and then selecting the lowest binary polarity still candidate for selection, by carrying out the following operations:
- activation of the selection common line corresponding to a selected bit with polarity 0 (SBPZ), if an active signal is received on the candidature common line corresponding to a candidate bit of polarity 0 (CBPZ);
- otherwise, activation of the selection common line corresponding to a selected bit of polarity 1 (SBPO), if an active signal is received on the candidature common line corresponding to a candidate bit of polarity 1 (CBPO), and if simultaneously the corresponding bit (HTVB) of said high threshold numerical value has the polarity 1.

## Patentansprüche

1. Wahlvorrichtung aufgrund numerischer Auswahlwerte zur Auswahl von mindestens einem Element aus einer Untergruppe von C Elementen von Auswahlkandidaten, welche Teil einer Gruppe von M möglichen Elementen sind, wobei einem jeden der M möglichen Elemente ein numerischer Auswahlwert unter N möglichen numerischen Auswahlwerten zugewiesen wird,
wobei die besagte Vorrichtung eine zweidimensionale Matrix für die prioritätsbedingte Auswahl (PSA) umfasst, welche M x P in M Leitungen und P Spalten organisierte Auswahlzellen verwendet, wobei P die Anzahl der binären Elemente, oder Bits, ist, welche für die Codierung von N verschiedenen Werten erforderlich sind, wobei die Zelle (i, j) dem Schnittpunkt einer Leitung des Elements i und einer Spalte des Bits j entspricht,
wobei ein jedes der besagten M möglichen Elemente einer der besagten M Leitungen entspricht, welcher der diesem Element zugewiesene numerische Auswahlwert zugeordnet ist,
und wobei eine jede der besagten Leitungen an ihrem Elementeingang (EEi) ein Signal eines Kandidatenelements (ECi), empfängt, welches anzeigt, ob das entsprechende Element ein Kandidatenelement für die Auswahl ist oder nicht, und an ihrem Elementausgang (SEi) ein Signal eines ausgewählten Elements (ESi) ausgibt, welches anzeigt, ob das entsprechende Element ein ausgewähltes Element ist oder nicht,
wobei die Auswahl anhand einer spaltenweisen Analyse der binären Elemente, welche die besagten numerischen Auswahlwerte in der besagten Matrix für die prioritätsbedingte Auswahl codieren, erfolgt,
wobei die für eine Spalte vom Rang j ausgeführte Wahl für jede Zelle (i, j) der M Elemente das Übertragen oder Nicht-Übertragen eines Signals eines ausgewählten binären Elements (BRij) an die Zelle vom Rang j+1 desselben Elements bedingt, wobei dieses Signal nun dem besagten Signal des ausgewählten Elements (ESi) entspricht, welches anzeigt, ob das entsprechende Element ein ausgewähltes Element ist oder nicht, wenn die Zelle vom Rang j dem letzten Bit der niedrigsten Ordnung entspricht;
**dadurch gekennzeichnet, dass** sie eine Auswahleinheit (PSU) umfasst, welche über P Gruppen von gemeinsamen Leitungen, die den besagten P Spalten der besagten Matrix entsprechen, an die besagte Matrix (PSA) angeschlossen ist, wobei diese Einheit den Prozess der bitweisen Auswahl in jeder Zelle (PSCi,j) der besagten Matrix (PSA) steuert, wobei jede Zelle an die Gruppe von gemeinsamen Leitungen der entsprechenden Spalte j angeschlossen ist,
und dass die besagte Auswahleinheit (PSU) auf mindestens einer gemeinsamen Leitung je Spalte für ein jedes der P Bits die ausgewählte binäre Polarität, welche sich aus der von ihr gesteuerten Auswahl pro Spalte j ergibt, bereitstellt.

2. Vorrichtung zur Auswahl von Elementen aufgrund numerischer Auswahlwerte nach Anspruch 1, **dadurch gekennzeichnet, dass** P = log2N ist, wobei die besagten numerischen Auswahlwerte gemäß der natürlichen binären Codierung codiert werden.

3. Vorrichtung zur Auswahl von Elementen aufgrund numerischer Auswahlwerte nach Anspruch 1, **dadurch gekennzeichnet, dass** eine jede der besagten P Gruppen von gemeinsamen Leitungen umfasst:
- zwei gemeinsame Kandidatenleitungen, welche von der besagten Matrix (PSA) bis zur besagten Auswahleinheit (PSU) reichen, wobei eine erste gemeinsame Kandidatenleitung (CBPOj) anzeigt, ob eine binäre Polarität 1 als Kandidat für die Auswahl unter allen Zellen i, j der entsprechenden Spalte j vorhanden ist oder nicht, und eine zweite gemeinsame Kandidatenleitung (CBPZj) anzeigt, ob eine binäre Polarität 0 als Kandidat für die Auswahl unter allen Zellen (i, j) der entsprechenden Spalte j vorhanden ist oder nicht; und
- zwei gemeinsame Auswahlleitungen, welche von der besagten Auswahleinheit (PSU) bis zur besagten Matrix (PSA) reichen, wobei eine erste gemeinsame Auswahlleitung (SBPOj) anzeigt, ob die binäre Polarität 1 unter allen Zellen (i, j) der entsprechenden Spalte j ausgewählt ist oder nicht, und eine zweite gemeinsame Auswahlleitung (SBPZj) anzeigt, ob die binäre Polarität 0 unter allen Zellen (i, j) der entsprechenden Spalte j ausgewählt ist oder nicht.

4. Vorrichtung zur Auswahl von Elementen aufgrund numerischer Auswahlwerte nach Anspruch 1, **dadurch gekennzeichnet, dass** in der besagten Matrix (PSA) jede Zelle zur prioritätsbedingten Auswahl (PSCi, j), welche einem bestimmten Element (Ei) und einem bestimmten binären Element (Bj) entspricht, wie folgt angeschlossen ist:
- gemäß der Dimension M, an die vorhergehende Zelle (PSCi), j-1) über eine eingehende Leitung des binären Kandidatenelements (EBCi, j), um ein Eingangssignal des ausgewählten binären Elements (BRi, j-1/j) zu empfangen, und an die nachfolgende Zelle (PSCi, j+1) über eine ausgehende Leitung des ausgewählten binären Elements (SBRi, j), um ein Ausgangssignal des ausgewählten binären Elements (BRi, j/j+1) zu übertragen, wobei jede eingehende Leitung des binären Kandidatenelements (EBCi, j) an die ausgehende Leitung des ausgewählten binären Elements (SBSi, j-1) der vorangehenden Zelle und jede ausgehende Leitung des ausgewählten binären Kandidatenelements (SBSi, j) an die eingehende Leitung des binären Kandidatenelements (EBCi, j+1) der nachfolgenden Zelle angeschlossen ist, und wobei die eingehende Leitung des binären Kandidatenelements (EBCi, 1) der ersten Zelle (PSCi, 1) an den Eingang der Matrix (EEi) des Elements (Ei), welches das besagte Signal des Kandidatenelements (ECi) empfängt, angeschlossen ist, und die ausgehende Leitung des ausgewählten binären Elements (SBSi, p) der letzten Zelle (PSCi, p) an den Ausgang der Matrix (SEi) des Elements (Ei), welches das besagte Signal des ausgewählten Elements (ESi) ausgibt, angeschlossen ist;
- und gemäß der Dimension P, an die Gruppe der das binäre Element (Bj) betreffenden gemeinsamen Leitungen (BSj), welche zwei gemeinsame Kandidatenleitungen (CBPZj und CPBOj), die alle Zellen (PSCi, j), die sich auf dasselbe binäre Element (Bj) beziehen, miteinander verbinden, sowie die Einheit für die prioritätsbedingte Auswahl (PSU) und zwei gemeinsame Auswahlleitungen, welche von der Einheit für die prioritätsbedingte Auswahl kommen, umfasst, wobei eine erste gemeinsame Auswahlleitung (SBPOj) anzeigt, ob die binäre Polarität 1 unter allen Zellen (i, j) der entsprechenden Spalte j ausgewählt ist oder nicht, und die zweite gemeinsame Auswahlleitung (SBPZj) anzeigt, ob die binäre Polarität 0 unter allen Zellen (i, j) der entsprechenden Spalte j ausgewählt ist oder nicht.

5. Vorrichtung zur Auswahl von Elementen aufgrund numerischer Auswahlwerte nach Anspruch 1, **dadurch gekennzeichnet, dass** der mindestens bestimmten der besagten Elemente zugeordnete numerische Auswahlwert ein fester Wert ist und implizit in die Zellen eines jeden Elements mit festem numerischen Wert integriert wird, wobei eine jede der entsprechenden Zellen gemäß der Polarität des impliziten binären Elements in dem besagten festen numerischen Wert differenziert wird.

6. Vorrichtung zur Auswahl von Elementen aufgrund numerischer Auswahlwerte nach den Ansprüchen 4 und 5, **dadurch gekennzeichnet, dass** eine jede der besagten Zellen der Elemente mit einem festen numerischen Wert umfasst:
- Eine Entkopplungsdiode (D), welche ein "ODER KABEL" bildet und das besagte Eingangssignal des ausgewählten binären Elements (BRi, j-1/j) an die der beiden gemeinsamen Kandidatenleitungen (CBPZj oder CBPOj), deren binäre Polarität der binären Polarität des dieser Zelle zugeordneten impliziten binären Elements des festen numerischen Auswahlwerts entspricht, leitet, wodurch angezeigt wird, ob somit, auf den gemeinsamen Kandidatenleitungen, die binäre Polarität dieses impliziten Bits bei Aktivieren der geeigneten gemeinsamen Kandidatenleitung (CBPZj oder CBPOj), wenn das besagte Eingangssignal des ausgewählten binären Elements (BRi, j-1,j) aktiv ist;
- ein "UND"-Gatter (G), welche das besagte Ausgangssignal des ausgewählten binären Elements (BRi, j/j+1) ausgibt und von dem besagten Eingangssignal des ausgewählten binären Elements (BRi, j-1/j) und von dem der beiden gemeinsame Auswahlleitungen (SBPZj oder SBPOj), deren binäre Polarität der binären Polarität des dieser Zelle zugeordneten impliziten binären Elements entspricht, versorgt wird, wodurch angezeigt wird, ob die binäre Polarität, welche der binären Polarität dieses impliziten binären Elements entspricht, ausgewählt ist, so dass das besagte Ausgangssignal des ausgewählten binären Elements (BRi, j/j+1) aktiv ist, wenn das besagte Eingangssignal des ausgewählten binären Elements (BRi, j-1/j) aktiv ist und gleichzeitig ein aktives Signal auf der gemeinsame Auswahlleitung empfangen wird, deren binäre Polarität der binären Polarität des dieser Zelle zugeordneten impliziten binären Elements entspricht.

7. Vorrichtung zur Auswahl von Elementen aufgrund numerischer Auswahlwerte nach Anspruch 1, **dadurch gekennzeichnet, dass** der mindestens bestimmten der besagten Elemente zugeordnete numerische Auswahlwert explizit ist und dynamisch oder semi-permanent gespeichert wird.

8. Vorrichtung zur Auswahl von Elementen aufgrund numerischer Auswahlwerte nach Anspruch 7, **dadurch gekennzeichnet, dass** der besagte explizite numerische Auswahlwert innerhalb der besagten Matrix (PSA) gespeichert wird.

9. Vorrichtung zur Auswahl von Elementen aufgrund numerischer Auswahlwerte nach Anspruch 7, **dadurch gekennzeichnet, dass** der besagte explizite numerische Auswahlwert in einem externen Speicher gespeichert wird, welcher bitweise mit der besagten Matrix (PSA) assoziiert ist, wobei jede Zelle dieser Matrix von dem besagten externen Speicher ein binäres Element des gespeicherten numerischen Wertes empfängt.

10. Vorrichtung zur Auswahl von Elementen aufgrund numerischer Auswahlwerte nach einem beliebigen der Ansprüche 8 oder 9, **dadurch gekennzeichnet, dass** eine jede der besagten Zellen (PSCi, j) umfasst:
- zwei "UND"-Gatter mit zwei Eingängen (G1Z und G1O), wobei einer der Eingänge mit dem besagten Eingangssignal des ausgewählten binären Elements (BRi, j-1/j) verknüpft ist, wobei der andere Eingang des ersten "UND"-Gatters (G1Z), welches der Polarität 0 entspricht, mit der Polarität 0 des gespeicherten expliziten binären Elements verknüpft ist, und der andere Eingang des zweiten "UND"-Gatters (G1O), welches der Polarität 1 entspricht, mit der Polarität 1 des gespeicherten expliziten binären Elements verknüpft ist;
- zwei Entkopplungsdioden (DZ und DO), welche ein "ODER KABEL" bilden, wobei eine erste Diode (DZ) den Ausgang des besagten ersten "UND"-Gatters (G1Z) an die gemeinsame Kandidatenleitung mit der binären Polarität 0 (CBPZj) lenkt, und eine zweite Diode (DO) den Ausgang des besagten zweiten "UND"-Gatters (G1O) an die gemeinsame Kandidatenleitung mit der binären Polarität 1 (CBPOj) lenkt, wodurch auf diesen gemeinsamen Kandidatenleitungen die dem gespeicherten expliziten binären Element entsprechende binäre Polarität angezeigt wird, durch Aktivieren der geeigneten gemeinsamen Kandidatenleitung (CBPZj oder CBPOj), wenn das besagte Eingangssignal des ausgewählten binären Elements aktiv ist;
- und zwei weitere "UND"-Gatter mit zwei Eingängen (G2Z und G20), deren Ausgänge ein "ODER"-Gatter (G3), welches das besagte Ausgangssignal des ausgewählten binären Elements (BRi, j/j+1) ausgibt, versorgen, wobei ein Eingang des dritten "UND"-Gatters (G2Z), welches der Polarität 0 entspricht, mit dem Ausgang des besagten ersten "UND"-Gatters (G1Z) und ein anderer Eingang mit der gemeinsamen Auswahlleitung mit der Polarität 0 (SBPZj) verknüpft ist, und ein Eingang des vierten "UND"-Gatters (G2O), welches der Polarität 1 entspricht, mit dem Ausgang des besagten zweiten "UND"-Gatters (G1O) und ein anderer Eingang mit der anderen gemeinsamen Auswahlleitung mit der Polarität 1 (SBPOj) verknüpft ist, wodurch angezeigt wird, ob die binäre Polarität, welche der binären Polarität des gespeicherten expliziten binären Element entspricht, ausgewählt ist, so dass das besagte Ausgangssignal des ausgewählten binären Elements (BRi, j/j+1) aktiv ist, wenn das besagte Eingangssignal des ausgewählten binären Elements (BRi, j-1/j) aktiv ist und simultan ein aktives Signal auf der gemeinsamen Auswahlleitung, deren binäre Polarität der binären Polarität des gespeicherten dieser Zelle entsprechenden expliziten binären Elements entspricht, empfangen wird.

11. Vorrichtung zur Auswahl von Elementen aufgrund numerischer Auswahlwerte nach Anspruch 3, **dadurch gekennzeichnet, dass** sie eine Suche des größten numerischen Auswahlwerts durchführt, wobei die besagte Auswahleinheit (PSU) für ein jedes der besagten P binären Elemente die folgenden Schritte ausführt:
- wenn ein aktives Signal auf der gemeinsamen Kandidatenleitung, welche einem binären Kandidatenelement mit der Polarität 1 (CBPO) entspricht, empfangen wird, Aktivieren der gemeinsamen Auswahlleitung, welche einem ausgewählten binären Element mit der Polarität 1 (SBPO) entspricht,
- anderenfalls, wenn ein aktives Signal auf der gemeinsamen Kandidatenleitung, welche einem binären Kandidatenelement mit der Polarität 0 (CBPZ) entspricht, empfangen wird, Aktivieren der gemeinsamen Auswahlleitung, welche einem ausgewählten binären Element mit der Polarität 0 (SBPZ) entspricht.

12. Vorrichtung zur Auswahl von Elementen aufgrund numerischer Auswahlwerte nach Anspruch 3, **dadurch gekennzeichnet, dass** sie eine Suche des kleinsten numerischen Auswahlwerts durchführt, wobei die besagte Auswahleinheit (PSU) für ein jedes der besagten P binären Elemente die folgenden Schritte ausführt:
- wenn ein aktives Signal auf der gemeinsamen Kandidatenleitung, welche einem binären Kandidatenelement mit der Polarität 0 (CBPZ) entspricht, empfangen wird, Aktivieren der gemeinsamen Auswahlleitung, welche einem ausgewählten binären Element mit der Polarität 0 (SBPZ) entspricht,
- anderenfalls, wenn ein aktives Signal auf der gemeinsamen Kandidatenleitung, welche einem binären Kandidatenelement mit der Polarität 1 (CBPO) entspricht, empfangen wird, Aktivieren der gemeinsamen Auswahlleitung, welche einem ausgewählten binären Element mit der Polarität 1 (SBPO) entspricht.

13. Vorrichtung zur Auswahl von Elementen aufgrund numerischer Auswahlwerte nach Anspruch 1, um in der Vorrichtung ein Suche nach den Elementen mit einem gegebenen numerischen Wert (SSK) unter den C Auswahlkandidatenelementen, welche zu den M Elementen der Matrix (PSA) gehören, auszuführen,
**dadurch gekennzeichnet, dass** die besagte Vorrichtung weiterhin eine Elementidentifizierungseinheit aufgrund von gegebenen numerischen Auswahlwerten (ECSU) umfasst, welche über P Paare von gemeinsamen Auswahlleitungen, die von der besagten Identifizierungseinheit bis zur besagten Matrix (PSA) führen, an die besagte Matrix angeschlossen ist, wobei jedes Leitungspaar eine erste gemeinsame Auswahlleitung (SBPOj), welche anzeigt, ob für die entsprechende Spalte j die binäre Polarität 1 gewählt ist oder nicht, und eine zweite gemeinsame Auswahlleitung (SBPZj), welche anzeigt, ob für die entsprechende Spalte j die binäre Polarität 0 gewählt ist oder nicht, umfasst,
und **dadurch**, dass die besagte Elementidentifizierungseinheit:
- den Code des gesuchten numerischen Auswahlwerts (SSK) empfängt,
- und für jede Spalte j die besagten gemeinsamen Auswahlleitungen gemäß der Polarität der Bits des gegebenen, unter den C Auswahlkandidatenelementen gesuchten numerischen Wertes (SSK) positioniert.

14. Vorrichtung zur Auswahl von Elementen aufgrund numerischer Auswahlwerte nach Anspruch 13, **dadurch gekennzeichnet, dass** die besagte Einheit zur Identifizierung der Elemente gemäß einem gegebenen numerischen Auswahlwert (ECSU) ebenfalls ein Anwesenheitssignal mindestens eines identifizierten Elements ausgibt,
und **dadurch**, dass die besagte Einheit:
- über P Paare von gemeinsamen Kandidatenleitungen, welche von der Matrix bis zu der besagten Identifizierungseinheit (ECSU) führen, mit der Matrix (PSA) verbunden ist, wobei eine erste gemeinsame Kandidatenleitung (CBPOj) anzeigt, ob eine binäre Polarität 1 als Kandidat für die Auswahl unter allen Zellen i, j der entsprechenden Spalte j vorhanden ist oder nicht, und die zweite gemeinsame Kandidatenleitung (CBPZj) anzeigt, ob eine binäre Polarität 0 als Kandidat für die Auswahl unter allen Zellen i, j der entsprechenden Spalte j vorhanden ist oder nicht; und
- das Vorhandensein oder Nichtvorhandensein von gesuchten Elementen erkennt, indem sie einen bitweisen Vergleich zwischen den Codes der Auswahlkandidatenelemente, welche sie auf den besagten gemeinsamen Kandidatenleitungen empfängt, und dem Code des gegebenen, unter den C Auswahlkandidatenelementen gesuchten numerischen Auswahlwert (SSK) ausführt.

15. Vorrichtung zur Auswahl von Elementen aufgrund numerischer Auswahlwerte nach Anspruch 3, **dadurch gekennzeichnet, dass** sie eine Suche der numerischen Auswahlwerte, welche größer als oder gleich ein gegebener niedrigster numerischer Grenzwert (LTV) sind, durchführt, wobei die besagte Auswahleinheit (PSU) für ein jedes der besagten P binären Elemente, ein Filtern auf dem binären Kandidatenelement mit der Polarität 0 (CBPZ), welches nicht freigegeben ist, wenn das entsprechende Bit (LTVB) des besagten niedrigsten numerischen Grenzwerts die Polarität 1 aufweist, wie folgt durchführt:
- Aktivieren der gemeinsamen Auswahlleitung, welche einem ausgewählten binären Element mit der Polarität 1 (SBPO) entspricht, wenn ein aktives Signal auf der gemeinsamen Kandidatenleitung, welche einem binären Kandidatenelement mit der Polarität 1 (CBPO) entspricht, empfangen wird,
- Aktivieren der gemeinsamen Auswahlleitung, welche einem ausgewählten binären Element mit der Polarität 0 (SBPZ) entspricht, wenn ein aktives Signal auf der gemeinsamen Kandidatenleitung, welche einem binären Kandidatenelement mit der Polarität 0 (CBPZ) entspricht, empfangen wird, und wenn gleichzeitig das entsprechende Bit (LTVB) des besagten niedrigsten numerischen Grenzwerts die Polarität 0 aufweist.

16. Vorrichtung zur Auswahl von Elementen aufgrund numerischer Auswahlwerte nach Anspruch 3, **dadurch gekennzeichnet, dass** sie eine Suche der numerischen Auswahlwerte, welche kleiner als oder gleich ein gegebener höchster numerischer Grenzwert (HTV) sind, durchführt, wobei die besagte Auswahleinheit (PSU) für ein jedes der besagten P binären Elemente, ein Filtern auf dem binären Kandidatenelement mit der Polarität 1 (CBPO), welches nicht freigegeben ist, wenn das entsprechende Bit (HTVB) des besagten höchsten numerischen Grenzwerts die Polarität 0 aufweist, wie folgt durchführt:
- Aktivieren der gemeinsamen Auswahlleitung, welche einem ausgewählten binären Element mit der Polarität 1 (SBPO) entspricht, wenn ein aktives Signal auf der gemeinsamen Kandidatenleitung, welche einem binären Kandidatenelement mit der Polarität 1 (CBPO) entspricht, empfangen wird, und wenn gleichzeitig das entsprechende Bit (HTVB) des besagten höchsten numerischen Grenzwerts die Polarität 1 aufweist.
- Aktivieren der gemeinsamen Auswahlleitung, welche einem ausgewählten binären Element mit der Polarität 0 (SBPZ) entspricht, wenn ein aktives Signal auf der gemeinsamen Kandidatenleitung, welche einem binären Kandidatenelement mit der Polarität 0 (CBPZ) entspricht, empfangen wird.

17. Vorrichtung zur Auswahl von Elementen aufgrund numerischer Auswahlwerte nach den Ansprüchen 11 und 15, **dadurch gekennzeichnet, dass** sie eine Suche des größten numerischen Auswahlwerts unter den Werten, welche höher als oder gleich ein gegebener niedrigster numerischer Grenzwert (LTV) ist, durchführt, wobei die besagte Auswahleinheit (PSU) für ein jedes der besagten P binären Elemente, zuerst ein Filtern auf dem binären Kandidatenelement mit der Polarität 0 (CBPZ), welches nicht freigegeben ist, wenn das entsprechende Bit (LTVB) des besagten niedrigsten numerischen Grenzwerts die Polarität 1 aufweist, durchführt und anschließend die höchste binäre Polarität, welche noch Kandidat für die Auswahl ist, auswählt, unter Ausführen der folgenden Schritte:
- Aktivieren der gemeinsamen Auswahlleitung, welche einem ausgewählten binären Element mit der Polarität 1 (SBPO) entspricht, wenn ein aktives Signal auf der gemeinsamen Kandidatenleitung, welche einem binären Kandidatenelement mit der Polarität 1 (CBPO) entspricht, empfangen wird,
- anderenfalls, Aktivieren der gemeinsamen Auswahlleitung, welche einem ausgewählten binären Element mit der Polarität 0 (SBPZ) entspricht, wenn ein aktives Signal auf der gemeinsamen Kandidatenleitung, welche einem binären Kandidatenelement mit der Polarität 0 (CBPZ) entspricht, empfangen wird, und wenn gleichzeitig das entsprechende Bit (LTVB) des besagten niedrigsten numerischen Grenzwerts die Polarität 0 aufweist.

18. Vorrichtung zur Auswahl von Elementen aufgrund numerischer Auswahlwerte nach den Ansprüchen 11 und 16, **dadurch gekennzeichnet, dass** sie eine Suche des größten numerischen Auswahlwerts unter den Werten, welche niedriger als oder gleich ein gegebener höchster numerischer Grenzwert (HTV) ist, durchführt, wobei die besagte Auswahleinheit (PSU) für ein jedes der besagten P binären Elemente, zuerst ein Filtern auf dem binären Kandidatenelement mit der Polarität 1 (CBPO), welches nicht freigegeben ist, wenn das entsprechende Bit (HTVB) des besagten höchsten numerischen Grenzwerts die Polarität 0 aufweist, durchführt und anschließend die höchste binäre Polarität, welche noch Kandidat für die Auswahl ist, auswählt, unter Ausführen der folgenden Schritte:
- Aktivieren der gemeinsamen Auswahlleitung, welche einem ausgewählten binären Element mit der Polarität 1 (SBPO) entspricht, wenn ein aktives Signal auf der gemeinsamen Kandidatenleitung, welche einem binären Kandidatenelement mit der Polarität 1 (CBPO) entspricht, empfangen wird, und wenn gleichzeitig das entsprechende Bit (HTVB) des besagten höchsten numerischen Grenzwerts die Polarität 1 aufweist.
- anderenfalls, Aktivieren der gemeinsamen Auswahlleitung, welche einem ausgewählten binären Element mit der Polarität 0 (SBPZ) entspricht, wenn ein aktives Signal auf der gemeinsamen Kandidatenleitung, welche einem binären Kandidatenelement mit der Polarität 0 (CBPZ) entspricht, empfangen wird.

19. Vorrichtung zur Auswahl von Elementen aufgrund numerischer Auswahlwerte nach den Ansprüchen 12 und 15, **dadurch gekennzeichnet, dass** sie eine Suche des kleinsten numerischen Auswahlwerts unter den Werten, welche höher als oder gleich ein gegebener niedrigster numerischer Grenzwert (LTV) ist, durchführt, wobei die besagte Auswahleinheit (PSU) für ein jedes der besagten P binären Elemente, zuerst ein Filtern auf dem binären Kandidatenelement mit der Polarität 0 (CBPZ), welches nicht freigegeben ist, wenn das entsprechende Bit (LTVB) des besagten niedrigsten numerischen Grenzwerts die Polarität 1 aufweist, ausführt und anschließend die niedrigste binäre Polarität, welche noch Kandidat für die Auswahl ist, auswählt, unter Ausführen der folgenden Schritte:
- Aktivieren der gemeinsamen Auswahlleitung, welche einem ausgewählten binären Element mit der Polarität 0 (SBPZ) entspricht, wenn ein aktives Signal auf der gemeinsamen Kandidatenleitung, welche einem binären Kandidatenelement mit der Polarität 0 (CBPZ) entspricht, empfangen wird, und wenn gleichzeitig das entsprechende Bit (LTVB) des besagten niedrigsten numerischen Grenzwerts die Polarität 0 aufweist;
- anderenfalls, Aktivieren der gemeinsamen Auswahlleitung, welche einem ausgewählten binären Element mit der Polarität 1 (SBPO) entspricht, wenn ein aktives Signal auf der gemeinsamen Kandidatenleitung, welche einem binären Kandidatenelement mit der Polarität 1 (CBPO) entspricht, empfangen wird.

20. Vorrichtung zur Auswahl von Elementen aufgrund numerischer Auswahlwerte nach den Ansprüchen 12 und 16, **dadurch gekennzeichnet, dass** sie eine Suche des kleinsten numerischen Auswahlwerts unter den Werten, welche niedriger als oder gleich ein gegebener höchster numerischer Grenzwert (HTV) ist, durchführt, wobei die besagte Auswahleinheit (PSU) für ein jedes der besagten P binären Elemente, zuerst ein Filtern auf dem binären Kandidatenelement mit der Polarität 1 (CBPO), welches nicht freigegeben ist, wenn das entsprechende Bit (HTVB) des besagten höchsten numerischen Grenzwerts die Polarität 0 aufweist, ausführt und anschließend die niedrigste binäre Polarität, welche noch Kandidat für die Auswahl ist, auswählt, unter Ausführen der folgenden Schritte:
- Aktivieren der gemeinsamen Auswahlleitung, welche einem ausgewählten binären Element mit der Polarität 0 (SBPZ) entspricht, wenn ein aktives Signal auf der gemeinsamen Kandidatenleitung, welche einem binären Kandidatenelement mit der Polarität 0 (CBPZ) entspricht, empfangen wird,
- anderenfalls, Aktivieren der gemeinsamen Auswahlleitung, welche einem ausgewählten binären Element mit der Polarität 1 (SBPO) entspricht, wenn ein aktives Signal auf der gemeinsamen Kandidatenleitung, welche einem binären Kandidatenelement mit der Polarität 1 (CBPO) entspricht, empfangen wird, und wenn gleichzeitig das entsprechende Bit (HTVB) des besagten höchsten numerischen Grenzwerts die Polarität 1 aufweist.
